# EUROPEAN PATENT APPLICATION

(11) **EP 4 794 495 A1**
(43) Date of publication of application: **19.08.2026**
(21) Application number: 26157044.4
(22) Date of filing: 06.02.2026
(51) Int. Cl.: H10K 50/19, H10K 50/13, H10K 50/14, H10K 59/30, H10K 59/32

(54) **DISPLAY PANEL, METHOD OF MANUFACTURING THE DISPLAY PANEL, AND ELECTRONIC APPARATUS INCLUDING THE DISPLAY PANEL**

(30) Priority: 17.02.2025 KR 20250020347
(71) Applicant: Samsung Display Co., Ltd., Yongin-si, Gyeonggi-do 17113 (KR)
(72) Inventor: YOON, Seokgyu, 17113 Yongin-si (KR); KIM, Beomjoon, 17113 Yongin-si (KR); OH, Keunchan, 17113 Yongin-si (KR); YUN, Jinyoung, 17113 Yongin-si (KR); HAN, Sanghyun, 17113 Yongin-si (KR)
(74) Representative: Marks & Clerk LLP

(57) **Abstract**

A display panel includes: a first light-emitting element on a substrate, and including a first pixel electrode, a single first emission layer on the first pixel electrode, and an opposite electrode on the first emission layer; a second light-emitting element on the substrate, and including a second pixel electrode, a single second emission layer on the second pixel electrode, and the opposite electrode on the second emission layer; and a third light-emitting element on the substrate, and including a third pixel electrode, a lower emission layer on the third pixel electrode, a charge generation layer on the lower emission layer, an upper emission layer on the charge generation layer, and the opposite electrode on the upper emission layer. The charge generation layer is spaced from each of the first emission area and the second emission area in a plan view.

## Description

### BACKGROUND

### 1. Field

Aspects of embodiments of the present disclosure relate to a display panel, a method of manufacturing the display panel, and an electronic apparatus including the display panel.

### 2. Description of the Related Art

Recently, uses of display panels have been diversified. In addition, the thicknesses and weights of display panels have been decreased, and thus, the scope of their use is expanding.

Generally, a display panel includes a plurality of pixels that receive an electrical signal, and emit light in order to display an image. Pixels of the display panel include light-emitting elements as display elements, and each of the light-emitting elements includes a pixel electrode, an emission layer, and an opposite electrode.

### SUMMARY

Embodiments of the present disclosure may be directed to a display panel having an improved display quality, and a method of manufacturing the display panel. One or more embodiments of the present disclosure may be directed to an electronic apparatus including a display panel having an improved display quality. However, the aspects and features of the present disclosure are not limited thereto.

Additional aspects and features will be set forth, in part, in the description that follows, and in part, may be apparent from the description, or may be learned by practicing one or more of the presented embodiments of the present disclosure.

According to one or more embodiments of the present disclosure, a display panel includes: a substrate including a first emission area, a second emission area, and a third emission area; a first light-emitting element on the substrate, and corresponding to the first emission area to emit light of a first color, the first light-emitting element including a first pixel electrode, a single first emission layer on the first pixel electrode, and an opposite electrode on the first emission layer; a second light-emitting element on the substrate, and corresponding to the second emission area to emit light of a second color, the second light-emitting element including a second pixel electrode, a single second emission layer on the second pixel electrode, and the opposite electrode on the second emission layer; and a third light-emitting element on the substrate, and corresponding to the third emission area to emit light of a third color, the third light-emitting element including a third pixel electrode, a lower emission layer on the third pixel electrode, a charge generation layer on the lower emission layer, an upper emission layer on the charge generation layer, and the opposite electrode on the upper emission layer. The charge generation layer is spaced from each of the first emission area and the second emission area in a plan view.

In an embodiment, the third light-emitting element may have a greater number of emission layers than that of each of the first light-emitting element and the second light-emitting element.

In an embodiment, each of the first light-emitting element, the second light-emitting element, and the third light-emitting element may further include a first functional layer; the third light-emitting element may further include a second functional layer and a third functional layer; the first functional layer may be located between the first pixel electrode and the first emission layer, between the second pixel electrode and the second emission layer, and between the third pixel electrode and the lower emission layer; the second functional layer may be located between the lower emission layer and the charge generation layer; and the third functional layer may be located between the charge generation layer and the upper emission layer.

In an embodiment, each of the second functional layer and the third functional layer may be spaced from the first emission area and the second emission area in the plan view.

In an embodiment, each of the first light-emitting element, the second light-emitting element, and the third light-emitting element may further include a fourth functional layer; and the fourth functional layer may be located between the first emission layer and the opposite electrode, between the second emission layer and the opposite electrode, and between the upper emission layer and the opposite electrode.

In an embodiment, the display panel may further include a pixel-defining layer on the first pixel electrode, the second pixel electrode, and the third pixel electrode, the pixel-defining layer having a first pixel opening exposing a portion of the first pixel electrode, a second pixel opening exposing a portion of the second pixel electrode, and a third pixel opening exposing a portion of the third pixel electrode.

In an embodiment, the first functional layer, the second emission layer, the lower emission layer, the second functional layer, the charge generation layer, the third functional layer, and the upper emission layer may overlap with each other on the pixel-defining layer between the second pixel opening and the third pixel opening; and the first functional layer, the second emission layer, the lower emission layer, the second functional layer, the charge generation layer, the third functional layer, and the upper emission layer may be sequentially stacked.

In an embodiment, the first functional layer may include a hole injection layer, and a hole transport layer on the hole injection layer. Between the second pixel opening and the third pixel opening, a distance between an upper surface of the hole injection layer on the pixel-defining layer and a lower surface of the charge generation layer may be greater than a sum of a thickness of the hole transport layer located within the third pixel opening, a thickness of the lower emission layer located within the third pixel opening, and a thickness of the second functional layer located within the third pixel opening.

In an embodiment, between the second pixel opening and the third pixel opening, the second emission layer and the lower emission layer may not overlap with each other.

In an embodiment, the display panel may further include a capping layer on the opposite electrode.

According to one or more embodiments of the present disclosure, a method of manufacturing a display panel includes: forming a first pixel electrode, a second pixel electrode, and a third pixel electrode to be spaced from each other on a substrate; forming a first functional layer on the first pixel electrode, the second pixel electrode, and the third pixel electrode; forming a single first emission layer on the first functional layer in a region overlapping with the first pixel electrode; forming a single second emission layer on the first functional layer in a region overlapping with the second pixel electrode; and forming, in a region overlapping with the third pixel electrode, a lower emission layer on the first functional layer, a second functional layer on the lower emission layer, a charge generation layer on the second functional layer, a third functional layer on the charge generation layer, and an upper emission layer on the third functional layer. The charge generation layer is spaced from the first pixel electrode and the second pixel electrode in a plan view.

In an embodiment, the forming of the lower emission layer on the first functional layer in the region overlapping with the third pixel electrode may be performed after the forming of the first emission layer and the forming of the second emission layer.

In an embodiment, the method may further include: forming a fourth functional layer on the first emission layer, the second emission layer, and the upper emission layer; and forming an opposite electrode on the fourth functional layer.

In an embodiment, the method may further include forming a pixel-defining layer on the first pixel electrode, the second pixel electrode, and the third pixel electrode, the pixel-defining layer having a first pixel opening exposing a portion of the first pixel electrode, a second pixel opening exposing a portion of the second pixel electrode, and a third pixel opening exposing a portion of the third pixel electrode.

In an embodiment, the first functional layer, the second emission layer, the lower emission layer, the second functional layer, the charge generation layer, the third functional layer, and the upper emission layer may be sequentially stacked on the pixel-defining layer between the second pixel opening and the third pixel opening.

In an embodiment, the first functional layer may include a hole injection layer, and a hole transport layer on the hole injection layer. Between the second pixel opening and the third pixel opening, a distance between an upper surface of the hole injection layer on the pixel-defining layer and a lower surface of the charge generation layer may be greater than a sum of a thickness of the hole transport layer arranged within the third pixel opening, a thickness of the lower emission layer arranged within the third pixel opening, and a thickness of the second functional layer arranged within the third pixel opening.

According to one or more embodiments of the present disclosure, an electronic apparatus includes: a display module including a display panel; a processor; a memory; and a power module. The display panel includes: a substrate including a first emission area, a second emission area, and a third emission area; a first light-emitting element on the substrate, and corresponding to the first emission area to emit light of a first color, the first light-emitting element including a first pixel electrode, one first emission layer on the first pixel electrode, and an opposite electrode on the first emission layer; a second light-emitting element on the substrate, and corresponding to the second emission area to emit light of a second color, the second light-emitting element including a second pixel electrode, one second emission layer on the second pixel electrode, and the opposite electrode on the second emission layer; and a third light-emitting element on the substrate, and corresponding to the third emission area to emit light of a third color, the third light-emitting element including a third pixel electrode, a lower emission layer on the third pixel electrode, a charge generation layer on the lower emission layer, an upper emission layer on the charge generation layer, and the opposite electrode on the upper emission layer. The charge generation layer is spaced from each of the first emission area and the second emission area in a plan view.

In an embodiment, the third light-emitting element may have a greater number of emission layers than that of each of the first light-emitting element and the second light-emitting element.

In an embodiment, each of the first light-emitting element, the second light-emitting element, and the third light-emitting element may further include a first functional layer; the third light-emitting element may further include a second functional layer and a third functional layer; the first functional layer may be located between the first pixel electrode and the first emission layer, between the second pixel electrode and the second emission layer, and between the third pixel electrode and the lower emission layer; the second functional layer may be located between the lower emission layer and the charge generation layer; and the third functional layer may be located between the charge generation layer and the upper emission layer.

In an embodiment, each of the second functional layer and the third functional layer may be spaced from the first emission area and the second emission area in the plan view.

At least some of the above and other features of the invention are set out in the claims.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, nonlimiting embodiments with reference to the accompanying drawings, in which:
FIG. 1 is a plan view schematically illustrating a display panel according to an embodiment;
FIG. 2 is an equivalent circuit diagram of one pixel included in a display panel according to an embodiment;
FIG. 3 is a cross-sectional view schematically illustrating a structure of a display element according to an embodiment;
FIG. 4 is a plan view schematically illustrating a display area of a display panel according to an embodiment;
FIG. 5 is a cross-sectional view schematically illustrating a cross-section taken along the line I-I' of FIG. 4;
FIG. 6 is a cross-sectional view illustrating an enlargement of the area A of FIG. 5;
FIG. 7 is a plan view schematically illustrating a display area of a display panel according to an embodiment;
FIG. 8 is a cross-sectional view schematically illustrating a cross-section taken along the line II-II' of FIG. 7;
FIGS. 9-16 are cross-sectional views schematically illustrating a method of manufacturing a display panel according to an embodiment;
FIG. 17 is a graph illustrating a lateral leakage current ratio when driving a light-emitting element according to an embodiment, and a lateral leakage current ratio when driving a light-emitting element according to comparative examples;
FIG. 18 is a block diagram of an electronic apparatus according to an embodiment; and
FIG. 19 is schematic diagrams of electronic apparatuses according to some embodiments.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x direction, the y direction, and the z direction are not limited to directions corresponding to three axes of the rectangular coordinate system, and may be interpreted in a broader sense. For example, the x direction, the y direction, and the z direction may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected to the other layer, area, or element with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expressions "at least one of a, b, or c," "at least one of a, b, and c," and "at least one selected from the group consisting of a, b, and c" indicate only a, only b, only c, both a and b, both a and c, both b and c, all of a, b, and c, or variations thereof.

As used herein, the terms "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present disclosure described herein (e.g., the various units and modules) may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

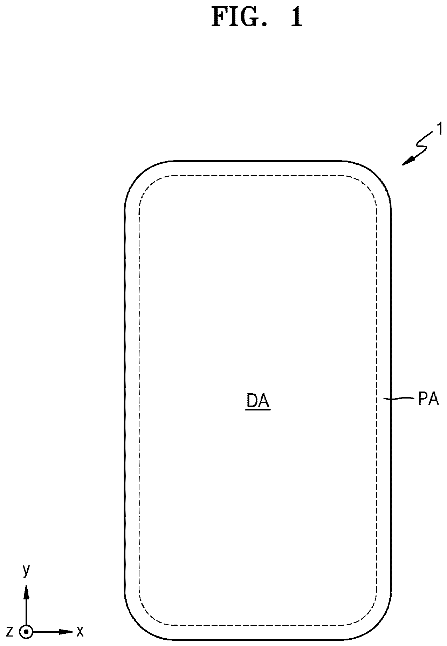

FIG. 1 is a plan view schematically illustrating a display panel 1 according to an embodiment.

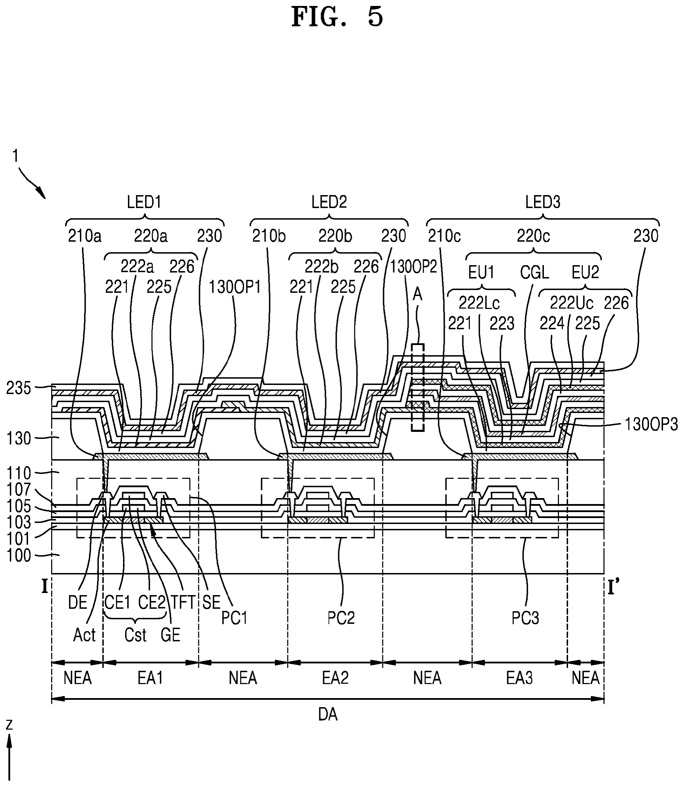

Referring to FIG. 1, the display panel 1 may include a display area DA that displays an image, and a peripheral area PA outside the display area DA. The display panel 1 may provide an image by using light emitted from a plurality of pixels arranged in the display area DA. As used herein, a pixel refers to a sub-pixel that emits light of a desired color (e.g., a certain or predetermined color). For example, each of the plurality of pixels may emit a red light, a green light, or a blue light. As another example, each of the plurality of pixels may emit a red light, a green light, a blue light, or a white light. Because the display panel 1 includes a substrate 100 (e.g., see FIG. 5) as described in more detail below, it may be understood that the substrate 100 includes the display area DA and the peripheral area PA.

In a plan view, the display area DA may have a rectangular shape. In other embodiments, the display area DA may have another suitable polygonal shape, a circular shape, an elliptical shape, an irregular shape, or the like. The display area DA may have a shape having rounded corners at the edges thereof.

In an embodiment, the display panel 1 may have a display area DA of which a length in a first direction (e.g., the x direction) is less than a length in a second direction (e.g., the y direction), as shown in FIG. 1. However, the present disclosure is not limited thereto, and the display panel 1 may have a display area DA of which the length in the first direction (e.g., the x direction) is greater than the length in the second direction (e.g., the y direction).

The peripheral area PA is arranged around the display area DA, and the peripheral area PA may surround (e.g., around a periphery of) at least a portion of the display area DA. In an embodiment, the peripheral area PA may be a kind of non-display area where the pixels are not arranged. The peripheral area PA may include wires that transmit electrical signals to be applied to the display area DA, circuits, and pads to which a printed circuit board or a driver integrated circuit (IC) chip is attached.

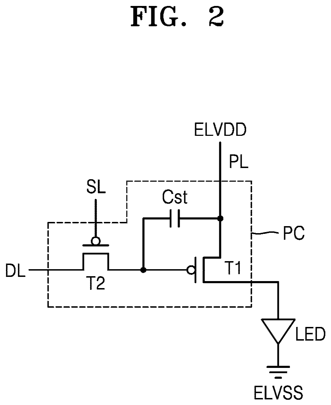

FIG. 2 is an equivalent circuit diagram of one pixel included in a display panel according to an embodiment.

Referring to FIG. 2, one pixel included in the display panel 1 may include a pixel circuit PC, and a light-emitting element LED electrically connected to the pixel circuit PC.

The pixel circuit PC may include a first transistor T1, a second transistor T2, and a capacitor Cst. The pixel circuit PC may be electrically connected to a scan line SL and a data line DL. The first transistor T1 may be a driving transistor, and the second transistor T2 may be a switching transistor. The second transistor T2 may be electrically connected to the scan line SL and the data line DL, and may transmit a data signal input through the data line DL to the first transistor T1 according to a scan signal input through the scan line SL.

The capacitor Cst may be connected to the second transistor T2 and a driving voltage line PL, and may store a voltage corresponding to a difference between the data signal received from the second transistor T2 and a driving voltage ELVDD supplied from the driving voltage line PL.

The light-emitting element LED may include a pixel electrode (e.g., anode), an opposite electrode (e.g., cathode), and an intermediate layer arranged between the pixel electrode and the opposite electrode. A common voltage ELVSS may be applied to the opposite electrode.

The first transistor T1 may be connected to the driving voltage line PL and the capacitor Cst, and may control a driving current flowing from the driving voltage line PL to the light-emitting element LED in response to a value (e.g., a voltage) stored in the capacitor Cst. The light-emitting element LED may emit light having a desired brightness (e.g., a certain or predetermined brightness) by using the driving current.

Although FIG. 2 illustrates that the pixel circuit PC includes two transistors and one capacitor, the present disclosure is not limited thereto. In another embodiment, the pixel circuit PC may include three or more transistors and/or two or more capacitors.

In addition, although FIG. 2 illustrates that both the first transistor T1 and the second transistor T2 are provided as P-type transistors, the present disclosure is not limited thereto. In another embodiment, some of the transistors included in the pixel circuit PC may be provided as N-type transistors, and the others may be provided as P-type transistors. In another embodiment, all of the transistors may be provided as N-type transistors.

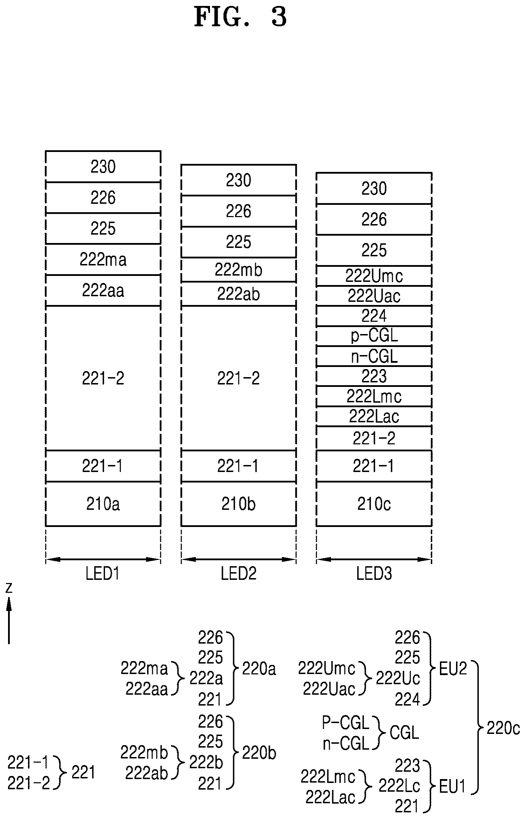

FIG. 3 is a cross-sectional view schematically illustrating a structure of a display element according to an embodiment.

Referring to FIG. 3, the display element according to an embodiment may be a light-emitting element. A first light-emitting element LED1 included in a first pixel may include a first pixel electrode 210a, an opposite electrode 230, and a first intermediate layer 220a between the first pixel electrode 210a and the opposite electrode 230. A second light-emitting element LED2 included in a second pixel may include a second pixel electrode 210b, the opposite electrode 230, and a second intermediate layer 220b between the second pixel electrode 210b and the opposite electrode 230. A third light-emitting element LED3 included in a third pixel may include a third pixel electrode 210c, the opposite electrode 230, and a third intermediate layer 220c between the third pixel electrode 210c and the opposite electrode 230. In an embodiment, the first light-emitting element LED1, the second light-emitting element LED2, and the third light-emitting element LED3 may emit light of different colors from each other.

The first pixel electrode 210a, the second pixel electrode 210b, and the third pixel electrode 210c may be independently provided in the first light-emitting element LED1, the second light-emitting element LED2, and the third light-emitting element LED3, respectively. For example, the first pixel electrode 210a, the second pixel electrode 210b, and the third pixel electrode 210c may be arranged to be spaced apart from each other in a plan view.

Each of the first to third pixel electrodes 210a, 210b, and 210c may include a transparent conductive oxide, such as indium tin oxide (ITO), indium zinc oxide (IZO), zinc oxide (ZnO), indium oxide (In₂O₃), indium gallium oxide (IGO), indium gallium zinc oxide (IGZO), gallium zinc oxide (GZO), or aluminium zinc oxide (AZO). The pixel electrode 210a, 210b, or 210c may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a suitable compound thereof. For example, the pixel electrode 210a, 210b, or 210c may have a three-layered structure including ITO/Ag/ITO layers.

The opposite electrode 230 may be arranged on the first intermediate layer 220a, the second intermediate layer 220b, and the third intermediate layer 220c. The opposite electrode 230 may include a metal, an alloy, an electrically conductive compound, or any suitable combination thereof having a low work function. For example, the opposite electrode 230 may include a (semi)transparent layer including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), or a suitable alloy thereof. As another example, the opposite electrode 230 may further include a layer including such as an ITO, IZO, ZnO, or In₂O₃, on the (semi)transparent layer including at least one of the aforementioned materials.

Each of the first intermediate layer 220a, the second intermediate layer 220b, and the third intermediate layer 220c may include a high-molecular weight or low-molecular weight organic material that emits light of a desired color (e.g., a certain or predetermined color). In addition to various organic materials, the first intermediate layer 220a, the second intermediate layer 220b, and the third intermediate layer 220c may each further include a metal-containing compound such as an organometallic compound, an inorganic material such as quantum dots, and/or the like.

In an embodiment, the first intermediate layer 220a may include one emitting unit between the first pixel electrode 210a and the opposite electrode 230. In an embodiment, the second intermediate layer 220b may include one emitting unit between the second pixel electrode 210b and the opposite electrode 230. Each of the first light-emitting element LED1 and the second light-emitting element LED2 may include a single stack structure including a single emission layer. For example, each of the first light-emitting element LED1 and the second light-emitting element LED2, each including one emitting unit, may be referred to as a single stack structure light-emitting element.

In an embodiment, the third intermediate layer 220c may include two or more emitting units that are sequentially stacked between the third pixel electrode 210c and the opposite electrode 230, and a charge generation layer CGL arranged between the two emitting units. The third light-emitting element LED3 may include a multi-stacked structure including a plurality of emission layers. For example, the third light-emitting element LED3 including the third intermediate layer 220c including a plurality of emitting units and the charge generation layer CGL may be referred to as a tandem light-emitting element.

As used herein, a single stack structure may be defined as including a single emission layer, and a tandem structure or a multi-stacked structure may be defined as including a plurality of emission layers.

One emitting unit may include an emission layer, and a lower functional layer and an upper functional layer below and above the emission layer, respectively. The lower functional layer may include a hole transport layer (HTL), or may include an HTL and a hole injection layer (HIL). The upper functional layer may be arranged on the emission layer, and may be selectively included as needed or desired. The upper functional layer may include an electron transport layer (ETL) and/or an electron injection layer (EIL).

Each of the first intermediate layer 220a of the first light-emitting element LED1 and the second intermediate layer 220b of the second light-emitting element LED2 may include a single emitting unit. For example, each of the first intermediate layer 220a of the first light-emitting element LED1 and the second intermediate layer 220b of the second light-emitting element LED2 may include a single emission layer. The emission layer may include a light-emitting material. Each of the first light-emitting element LED1 and the second light-emitting element LED2 may not include a charge generation layer CGL.

The first intermediate layer 220a of the first light-emitting element LED1 may include a first functional layer 221, a first light-emitting structure 222a including a first emission auxiliary layer 222aa and a first emission layer 222ma, a light-emitting element buffer layer 225, and a fourth functional layer 226, which are sequentially stacked on the first pixel electrode 210a. For example, the first light-emitting element LED1 may include a single emitting unit including a single first light-emitting structure 222a (e.g., a single first emission layer 222ma) between the first functional layer 221 and the fourth functional layer 226.

The second intermediate layer 220b of the second light-emitting element LED2 may include a first functional layer 221, a second light-emitting structure 222b including a second emission auxiliary layer 222ab and a second emission layer 222mb, a light-emitting element buffer layer 225, and a fourth functional layer 226, which are sequentially stacked on the second pixel electrode 210b. For example, the second light-emitting element LED2 may include a single emitting unit including a single second light-emitting structure 222b (e.g., a single second emission layer 222mb) between the first functional layer 221 and the fourth functional layer 226.

The third intermediate layer 220c of the third light-emitting element LED3 may include a first emitting unit EU1, a second emitting unit EU2 on the first emitting unit EU1, and a charge generation layer CGL between the first emitting unit EU1 and the second emitting unit EU2. The first emitting unit EU1 may include a first functional layer 221, a lower light-emitting structure 222Lc including a lower emission auxiliary layer 222Lac and a lower emission layer 222Lmc, and a second functional layer 223. The second emitting unit EU2 may include a third functional layer 224, an upper light-emitting structure 222Uc including an upper emission auxiliary layer 222Uac and an upper emission layer 222Umc, a light-emitting element buffer layer 225, and a fourth functional layer 226. For example, the third intermediate layer 220c of the third light-emitting element LED3 may include a first functional layer 221, a lower emission auxiliary layer 222Lac, a lower emission layer 222Lmc, a second functional layer 223, a charge generation layer CGL, a third functional layer 224, an upper emission auxiliary layer 222Uac, an upper emission layer 222Umc, a light-emitting element buffer layer 225, and a fourth functional layer 226, which are sequentially stacked on the third pixel electrode 210c.

The first light-emitting structure 222a, the second light-emitting structure 222b, and a third light-emitting structure including the lower light-emitting structure 222Lc and the upper light-emitting structure 222Uc may be patterned and independently provided in the first light-emitting element LED1, the second light-emitting element LED2, and the third light-emitting element LED3, respectively. For example, the first emission auxiliary layer 222aa and the first emission layer 222ma may be patterned and independently provided in the first light-emitting element LED1. For example, the second emission auxiliary layer 222ab and the second emission layer 222mb may be patterned and independently provided in the second light-emitting element LED2. The lower emission auxiliary layer 222Lac, the lower emission layer 222Lmc, the upper emission auxiliary layer 222Uac, and the upper emission layer 222Umc may be patterned and independently provided in the third light-emitting element LED3.

The first emission layer 222ma, the second emission layer 222mb, and the third emission layer including the lower emission layer 222Lmc and the upper emission layer 222Umc may emit light of different colors from each other. The lower emission layer 222Lmc and the upper emission layer 222Umc may be arranged to overlap with each other, and may emit light of the same color as each other. For example, the first emission layer 222ma may emit light of a first color, the second emission layer 222mb may emit light of a second color, and the lower emission layer 222Lmc and the upper emission layer 222Umc may emit light of a third color. For example, the first emission layer 222ma may emit a red light, the second emission layer 222mb may emit a green light, and the lower emission layer 222Lmc and the upper emission layer 222Umc may emit a blue light.

Each of the first emission layer 222ma, the second emission layer 222mb, the lower emission layer 222Lmc, and the upper emission layer 222Umc may include an organic material including a fluorescent or a phosphorescent material that emits a red light, a green light, or a blue light. Each of the first emission layer 222ma, the second emission layer 222mb, the lower emission layer 222Lmc, and the upper emission layer 222Umc may be an organic emission layer including a low-molecular weight organic material or a high-molecular weight organic material.

In an embodiment, each of the first emission layer 222ma, the second emission layer 222mb, the lower emission layer 222Lmc, and the upper emission layer 222Umc may include a host material and a dopant material. The dopant material may be a material that emits a desired color (e.g., a certain or predetermined color), and may include a light-emitting material. The light-emitting material may include at least one of a phosphorescent dopant, a fluorescent dopant, and/or a quantum dot. The host material may be a main material of the emission layer that helps the dopant material to emit light.

Each of the first emission auxiliary layer 222aa and the second emission auxiliary layer 222ab may include a resonance auxiliary material as a layer added to match a resonance distance of each light-emitting element. In an embodiment, each of the lower emission auxiliary layer 222Lac and the upper emission auxiliary layer 222Uac may include a resonance auxiliary material as a layer added to match a resonance distance of each light-emitting element. In an embodiment, each of the first emission auxiliary layer 222aa, the second emission auxiliary layer 222ab, the lower emission auxiliary layer 222Lac, and the upper emission auxiliary layer 222Uac may include an electron blocking layer (EBL). In an embodiment, each of the first emission auxiliary layer 222aa, the second emission auxiliary layer 222ab, and the lower emission auxiliary layer 222Lac may include the same material as that of a first-2 functional layer 221-2. In an embodiment, the lower emission auxiliary layer 222Lac and the upper emission auxiliary layer 222Uac may be omitted as needed or desired.

In an embodiment, the thickness and distance of each layer may be set so that light emitted from each of the first light-emitting element LED1 and the second light-emitting element LED2 resonates secondarily. In an embodiment, the thickness and distance of each layer may be set so that light emitted from the third light-emitting element LED3 resonates primarily and resonates secondarily. For example, the thickness of a portion of the first-2 functional layer 221-2 arranged under the first light-emitting element LED1 and the second light-emitting element LED2 may be greater than the thickness of a portion of the first-2 functional layer 221-2 arranged under the third light-emitting element LED3. In an embodiment, the thickness and distance of each layer may be set so that the light emitted from the third light-emitting element LED3 resonates secondarily and resonates thirdly.

In an embodiment, the charge generation layer CGL may be provided in (e.g., only in) the third light-emitting element LED3, and may not be provided in the first light-emitting element LED1 and the second light-emitting element LED2. The charge generation layer CGL may include a negative charge generation layer n-CGL and a positive charge generation layer p-CGL.

The negative charge generation layer n-CGL may be an N-type charge generation layer. The negative charge generation layer n-CGL may supply electrons. The negative charge generation layer n-CGL may include an N-type host material and an N-type dopant. The negative charge generation layer n-CGL may include an N-type dopant material and an N-type host material. The N-type dopant material may be a metal of Group 1 and Group 2 of the periodic table, an organic material capable of injecting electrons, or a suitable mixture thereof. For example, the N-type dopant material may be any one of an alkali metal and/or an alkaline earth metal. In other words, the negative charge generation layer n-CGL may include an organic layer doped with an alkali metal, such as lithium (Li), sodium (Na), potassium (K), or cesium (Cs), or an alkaline earth metal, such as magnesium (Mg), strontium (Sr), barium (Ba), or radium (Ra). However, the present disclosure is not limited thereto. The N-type host material may include an organic material capable of transferring electrons. For example, the N-type host material may include at least one of Alq3 (tris(8-hydroxyquinolino)aluminium), Liq (8-hydroxyquinolinolato-lithium), PBD (2-(4-biphenylyl)-5-(4-tert-butylphenyl)-1,3,4-oxadiazole), TAZ (3-(4-biphenyl)4-phenyl-5-tert-butylphenyl-1,2,4-triazole), spiro-PBD, BAIq (bis(2-methyl-8-quinolinolate)-4-(phenylphenolato)aluminium), SAlq, TPBi (2,2',2-(1,3,5-benzinetriyl)-tris(1-phenyl-1-H-benzimidazole)), oxadiazole, triazole, phenanthroline, benzoxazole, or benzthiazole, but the present disclosure is not limited thereto.

The positive charge generation layer p-CGL may be a P-type charge generation layer. The positive charge generation layer p-CGL may supply holes. The positive charge generation layer p-CGL may include a P-type host material and a P-type dopant material. The P-type dopant material may include an organic material, such as tetrafluoro-tetracyanoquinodimethane (F4-TCNQ), hexaazatriphenylene-hexacarbonitrile (HAT-CN), or hexaazatriphenylene, or a metal oxide material, such as V₂O₅, MoOₓ, or WO₃, but the present disclosure is not limited thereto. The P-type host material may include an organic material capable of transferring holes, for example, such as a material including at least one of NPD (N,N-dinaphthyl-N,N'-diphenyl benzidine or N,N'-bis(naphthalene-1-yl)-N,N'-bis(phenyl)-2,2'-dimethylbenzidine), TPD (N,N'-bis-(3-methylphenyl)-N,N'-bis-(phenyl)-benzidine), and/or MTDATA (4,4',4-Tris(N-3-methylphenyl-N-phenyl-amino)-triphenylamine). However, the present disclosure is not limited thereto.

The first functional layer 221 may include a first-1 functional layer 221-1 and a first-2 functional layer 221-2. The first-1 functional layer 221-1 may be arranged on the first to third pixel electrodes 210a, 210b, and 210c, and the first-2 functional layer 221-2 may be arranged on the first-1 functional layer 221-1.

Each of the first-1 functional layer 221-1 and the first-2 functional layer 221-2 may be arranged between the first pixel electrode 210a and the first light-emitting structure 222a (e.g., the first emission layer 222ma), between the second pixel electrode 210b and the second light-emitting structure 222b (e.g., the second emission layer 222mb), and between the third pixel electrode 210c and the lower light-emitting structure 222Lc (e.g., the lower emission layer 222Lmc).

The first-1 functional layer 221-1 and the first-2 functional layer 221-2 may form a hole transport region. The hole transport region may have a single-layer structure or a multi-layered structure. For example, the first-1 functional layer 221-1 of the hole transport region may be an HIL, and the first-2 functional layer 221-2 of the hole transport region may be an HTL. In addition, in some embodiments, the hole transport region may further include an EBL. Each of the first-1 functional layer 221-1 and the first-2 functional layer 221-2 may be integrally formed or provided (e.g., commonly provided) across the first to third light-emitting elements LED1, LED2, and LED3.

In an embodiment, the second functional layer 223 may be patterned and formed to be provided in (e.g., only in) the third light-emitting element LED3. The second functional layer 223 may be arranged between the lower light-emitting structure 222Lc and the charge generation layer CGL. For example, the second functional layer 223 may be arranged between the lower emission layer 222Lmc and the charge generation layer CGL. For example, the second functional layer 223 may be arranged between the lower emission layer 222Lmc and the negative charge generation layer n-CGL.

The second functional layer 223 may be an ETL (e.g., an electron transport layer). The second functional layer 223 may be arranged under the negative charge generation layer n-CGL. The ETL may include the same material as that of the negative charge generation layer n-CGL. In this case, the negative charge generation layer n-CGL may be a layer doped with an N-type dopant in the same material as that of the ETL.

In an embodiment, the third functional layer 224 may be patterned and formed to be provided in (e.g., only in) the third light-emitting element LED3. The third functional layer 224 may be arranged between the charge generation layer CGL and the upper light-emitting structure 222Uc. For example, the third functional layer 224 may be arranged between the positive charge generation layer p-CGL and the upper light-emitting structure 222Uc. For example, the third functional layer 224 may be arranged between the positive charge generation layer p-CGL and the upper emission auxiliary layer 222Uac. For example, the third functional layer 224 may be arranged between the positive charge generation layer p-CGL and the upper emission layer 222Umc.

The third functional layer 224 may be a hole transport layer (HTL), and may transfer holes generated in the charge generation layer CGL to the second emitting unit EU2.

The light-emitting element buffer layer 225 and the fourth functional layer 226 may be arranged between the first light-emitting structure 222a (e.g., the first emission layer 222ma) and the opposite electrode 230, between the second light-emitting structure 222b (e.g., the second emission layer 222mb) and the opposite electrode 230, and between the upper light-emitting structure 222Uc (e.g., the upper emission layer 222Umc) and the opposite electrode 230. The light-emitting element buffer layer 225 may be integrally formed or provided (e.g., commonly provided) across the first to third light-emitting elements LED1, LED2, and LED3.

The light-emitting element buffer layer 225 may be arranged between the first emission layer 222ma and the fourth functional layer 226, between the second emission layer 222mb and the fourth functional layer 226, and between the upper emission layer 222Umc and the fourth functional layer 226. The light-emitting element buffer layer 225 may include an inorganic material, such as silicon oxide, silicon nitride, and/or silicon oxynitride.

The fourth functional layer 226 may form an electron transport region. The electron transport region may have a single-layer structure or a multi-layered structure. For example, the fourth functional layer 226 may include an ETL and/or an EIL. The fourth functional layer 226 may be integrally formed or provided (e.g., commonly provided) across the first to third light-emitting elements LED1, LED2, and LED3.

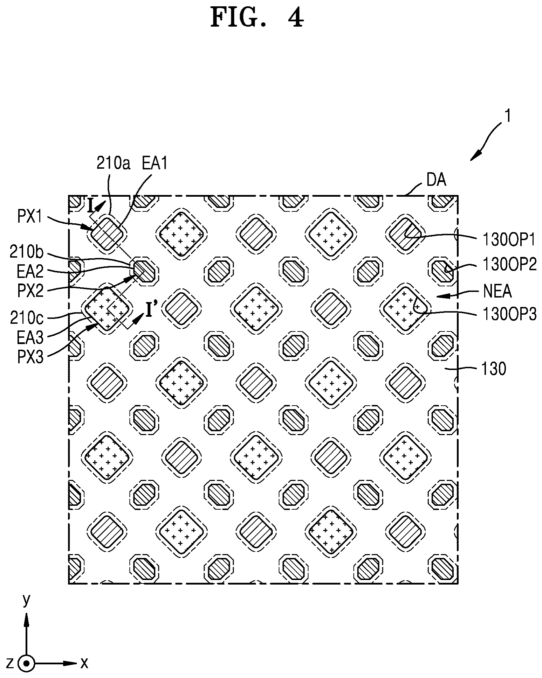

FIG. 4 is a plan view schematically illustrating a display area DA of a display panel 1 according to an embodiment.

Referring to FIG. 4, a plurality of pixels PX1, PX2, and PX3 may be arranged in the display area DA of the display panel 1. In an embodiment, each of the plurality of pixels PX1, PX2, and PX3 may include a display element, such as a light-emitting element, and a pixel circuit electrically connected to the display element. For example, a first pixel PX1 may include a first light-emitting element LED1 (e.g., see FIG. 5) and a first pixel circuit PC1. A second pixel PX2 may include a second light-emitting element LED2 (e.g., see FIG. 5) and a second pixel circuit PC2. A third pixel PX3 may include a third light-emitting element LED3 (e.g., see FIG. 5) and a third pixel circuit PC3.

In an embodiment, the plurality of pixels PX1, PX2, and PX3 may include the first pixel PX1, the second pixel PX2, and the third pixel PX3 that emit light of different colors from each other. For example, the first pixel PX1 may emit a red light, the second pixel PX2 may emit a green light, and the third pixel PX3 may emit a blue light. The red light may be light belonging to a wavelength band of about 580 nm to about 780 nm, the green light may be light belonging to a wavelength band of about 495 nm to about 580 nm, and the blue light may be light belonging to a wavelength band of about 400 nm to about 495 nm. In an embodiment, each of the first pixel PX1, the second pixel PX2, and the third pixel PX3 may emit a white light. Hereinafter, for convenience of illustration, the plurality of pixels PX1, PX2, and PX3 that emit light of different colors from each other may be described in more detail.

The first to third pixel electrodes 210a, 210b, and 210c may be arranged in the display area DA, and may be spaced apart from each other in a plan view.

A pixel-defining layer 130 may include a pixel opening that exposes a portion of each of the first to third pixel electrodes 210a, 210b, and 210c. For example, the pixel-defining layer 130 may include a first pixel opening 130OP1 that exposes a portion of the first pixel electrode 210a, a second pixel opening 130OP2 that exposes a portion of the second pixel electrode 210b, and a third pixel opening 130OP3 that exposes a portion of the third pixel electrode 210c. Emission layers that emit light may be respectively positioned within the pixel openings of the pixel-defining layer 130, and the opposite electrode 230 (e.g., see FIG. 3) may be arranged on the pixel-defining layer 130 and the emission layers. The opposite electrode 230 may be integrally formed or provided (e.g., commonly provided) across the first to third pixel electrodes 210a, 210b, and 210c.

Each of the first pixel opening 130OP1, the second pixel opening 130OP2, and the third pixel opening 130OP3 may have a polygonal shape in a plan view. However, the present disclosure is not limited thereto. In an embodiment, each of the first pixel opening 130OP1, the second pixel opening 130OP2, and the third pixel opening 130OP3 may have a polygonal shape, a circular shape, an oval shape, or the like. In an embodiment, each of the first pixel opening 130OP1, the second pixel opening 130OP2, and the third pixel opening 130OP3 may have a chamfered shape.

In an embodiment, the first pixel opening 130OP1, the second pixel opening 130OP2, and the third pixel opening 130OP3 may have different sizes (e.g., areas) from each other. For example, the size (e.g., the area) of the third pixel opening 130OP3 may be greater than the size (e.g., the area) of the first pixel opening 130OP1 and the size (e.g., the area) of the second pixel opening 130OP2. The size (e.g., the area) of the first pixel opening 130OP1 may be greater than or equal to the size (e.g., the area) of the second pixel opening 130OP2. In an embodiment, the first pixel opening 130OP1, the second pixel opening 130OP2, and the third pixel opening 130OP3 may have the same or substantially the same size (e.g., the same or substantially the same area) as each other.

The first pixel opening 130OP1 of the pixel-defining layer 130 may define a first emission area EA1 of the first pixel PX1, the second pixel opening 130OP2 of the pixel-defining layer 130 may define a second emission area EA2 of the second pixel PX2, and the third pixel opening 130OP3 of the pixel-defining layer 130 may define a third emission area EA3 of the third pixel PX3.

A non-emission area NEA may be provided between the plurality of pixels PX1, PX2, and PX3. The non-emission area NEA may be an area between the first emission area EA1 and the second emission area EA2, an area between the second emission area EA2 and the third emission area EA3, and an area between the third emission area EA3 and the first emission area EA1. The opposite electrode 230 (e.g., see FIG. 3) may be positioned in most of the non-emission area NEA, but the first to third pixel electrodes 210a, 210b, and 210c and the emission layers may not be positioned in the non-emission area NEA.

The display area DA of the display panel 1 may include the first emission area EA1, the second emission area EA2, the third emission area EA3, and the non-emission area NEA. Because the display panel 1 includes a substrate 100 (e.g., see FIG. 5) as described in more detail below, it may be understood that the substrate 100 includes the first emission area EA1, the second emission area EA2, the third emission area EA3, and the non-emission area NEA.

In FIG. 4, the plurality of pixels PX1, PX2, and PX3 are illustrated as being arranged in an RGBG kind (e.g., a PENTILE^{®} structure, PENTILE^{®} being a duly registered trademark of Samsung Display Co., Ltd.). However, the present disclosure is not limited thereto, and the arrangement of the first pixel PX1, the second pixel PX2, and the third pixel PX3 may be variously modified as needed or desired. For example, the first pixel PX1, the second pixel PX2, and the third pixel PX3 may be arranged according to a suitable rule (e.g., a certain or predetermined rule), such as a stripe arrangement, a PENTILE^{®} arrangement, a delta arrangement, or a diamond pentile^{®} arrangement.

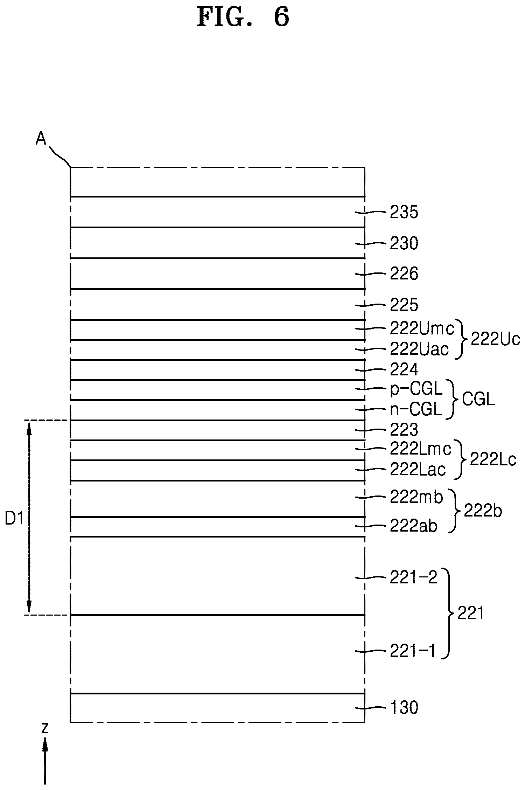

FIG. 5 is a cross-sectional view schematically illustrating a cross-section taken along the line I-I' of FIG. 4. FIG. 6 is a cross-sectional view illustrating an enlargement of the area A of FIG. 5.

Referring to FIG. 5, the display panel 1 may include a substrate 100, first to third pixel circuits PC1, PC2, and PC3 on the substrate 100, and display elements (e.g., the first light-emitting element LED1, a second light-emitting element LED2, and a third light-emitting element LED3) on the first to third pixel circuits PC1, PC2, and PC3.

The substrate 100 may include glass, a metal, or a polymer resin. The polymer resin may include polyethersulphone, polyacrylate, polyetherimide, polyethylene naphthalate, polyethylene terephthalate, polyphenylene sulfide, polyarylate, polyimide, polycarbonate, cellulose acetate propionate, or a suitable mixture thereof. In an embodiment, the substrate 100 may have a multi-layered structure including at least two base layers, each including the polymer resin, and an inorganic layer arranged between the base layers.

The first pixel circuit PC1, the second pixel circuit PC2, and the third pixel circuit PC3 may be arranged on a buffer layer 101. Each of the first to third pixel circuits PC1, PC2, and PC3 may include a transistor TFT and a capacitor Cst. The transistor TFT may include an active layer Act, a gate electrode GE, a source electrode SE, and a drain electrode DE.

The active layer Act may be arranged on the buffer layer 101. In an embodiment, the active layer Act may include a silicon-based semiconductor material, for example, such as amorphous silicon or polycrystalline silicon. In an embodiment, the active layer Act may include an oxide-based semiconductor material, for example, such as an oxide of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn).

A gate insulating layer 103 may be arranged on the active layer Act, and the gate electrode GE may be arranged on the gate insulating layer 103 to overlap with the active layer Act in a plan view. The gate electrode GE may include a conductive material, such as molybdenum (Mo), aluminium (Al), copper (Cu), titanium (Ti), indium tin oxide (ITO), or indium zinc oxide (IZO), and may include multilayers or a single layer including at least one of the aforementioned materials.

A first interlayer insulating layer 105 may be arranged on the gate electrode GE, and a second capacitor electrode CE2 may be arranged on the first interlayer insulating layer 105. At least a portion of the gate electrode GE may overlap with the second capacitor electrode CE2 in a plan view to function as a first capacitor electrode CE1 of the capacitor Cst. In other words, the gate electrode GE and the first capacitor electrode CE1 may be provided together as a single body. The second capacitor electrode CE2 may include a conductive material, such as molybdenum (Mo), aluminium (Al), copper (Cu), titanium (Ti), indium tin oxide (ITO), or indium zinc oxide (IZO), and may include multilayers or a single layer including at least one of the aforementioned materials.

A second interlayer insulating layer 107 may be arranged on the second capacitor electrode CE2, and the source electrode SE and the drain electrode DE may be arranged on the second interlayer insulating layer 107. Each of the source electrode SE and the drain electrode DE may include a conductive material, such as molybdenum (Mo), aluminium (Al), copper (Cu), titanium (Ti), indium tin oxide (ITO), or indium zinc oxide (IZO), and may include multilayers or a single layer including at least one of the aforementioned materials. For example, each of the source electrode SE and the drain electrode DE may have a multi-layered structure including Ti/Al/Ti layers.

Each of the gate insulating layer 103, the first interlayer insulating layer 105, and the second interlayer insulating layer 107 may include an inorganic material, such as silicon oxide, silicon nitride, and/or silicon oxynitride, and may include multilayers or a single layer including at least one of the aforementioned materials.

A via insulating layer 110 may be arranged on the first to third pixel circuits PC1, PC2, and PC3. The via insulating layer 110 may include an organic insulating material. For example, the via insulating layer 110 may include benzocyclobutene (BCB), hexamethyldisiloxane (HMDSO), polystyrene, a polymer derivative having a phenol-based group, an acryl-based polymer (e.g., polymethylmethacrylate (PMMA)), an imide-based polymer (e.g., polyimide), an acryl ether-based polymer, an amide-based polymer, a fluorine-based polymer, a p-xylene-based polymer, a vinyl alcohol-based polymer, a suitable blend thereof, or the like.

The first light-emitting element LED1, the second light-emitting element LED2, and the third light-emitting element LED3 may be arranged to be spaced apart from each other on the via insulating layer 110. The first light-emitting element LED1 may include a first pixel electrode 210a, a first intermediate layer 220a, and an opposite electrode 230. The second light-emitting element LED2 may include a second pixel electrode 210b, a second intermediate layer 220b, and an opposite electrode 230. The third light-emitting element LED3 may include a third pixel electrode 210c, a third intermediate layer 220c, and an opposite electrode 230.

The first pixel electrode 210a, the second pixel electrode 210b, and the third pixel electrode 210c may be spaced apart from each other on the via insulating layer 110. The first pixel electrode 210a may be electrically connected to the first pixel circuit PC1, the second pixel electrode 210b may be electrically connected to the second pixel circuit PC2, and the third pixel electrode 210c may be electrically connected to the third pixel circuit PC3.

A pixel-defining layer 130 may be arranged on the first pixel electrode 210a, the second pixel electrode 210b, and the third pixel electrode 210c. The pixel-defining layer 130 may cover an edge of the first pixel electrode 210a, an edge of the second pixel electrode 210b, and an edge of the third pixel electrode 210c. The pixel-defining layer 130 may include a first pixel opening 130OP1 exposing the center of the first pixel electrode 210a, a second pixel opening 130OP2 exposing the center of the second pixel electrode 210b, and a third pixel opening 130OP3 exposing the center of the third pixel electrode 210c.

The pixel-defining layer 130 may include an organic insulating material. As another example, the pixel-defining layer 130 may include an inorganic insulating material, such as silicon nitride, silicon oxynitride, or silicon oxide. As another example, the pixel-defining layer 130 may include an organic insulating material and an inorganic insulating material.

The first light-emitting element LED1 may be arranged corresponding to a first emission area EA1 defined by the first pixel opening 130OP1. The second light-emitting element LED2 may be arranged corresponding to a second emission area EA2 defined by the second pixel opening 130OP2. The third light-emitting element LED3 may be arranged corresponding to a third emission area EA3 defined by the third pixel opening 130OP3.

A first functional layer 221 may be arranged on the first pixel electrode 210a, the second pixel electrode 210b, the third pixel electrode 210c, and the pixel-defining layer 130, and may be integrally formed (e.g., commonly provided) across the first light-emitting element LED1, the second light-emitting element LED2, and the third light-emitting element LED3. In FIG. 5, for convenience of illustration, the thicknesses of portions of the first functional layer 221 respectively corresponding to the first to third light-emitting elements LED1, LED2, and LED3 are illustrated as being the same or substantially the same as each other, but as illustrated in FIG. 3, the thicknesses of the portions of the first functional layer 221 respectively corresponding to the first to third light-emitting elements LED1, LED2, and LED3 may be different from each other. For example, the thickness of a portion of the first functional layer 221 corresponding to the third light-emitting element LED3 may be less than the thicknesses of the portions of the first functional layer 221 respectively corresponding to the first light-emitting element LED1 and the second light-emitting element LED2.

For example, in the first emission area EA1, a first light-emitting structure 222a may be arranged on the first functional layer 221, a light-emitting element buffer layer 225 may be arranged on the first light-emitting structure 222a, and a fourth functional layer 226 may be arranged on the light-emitting element buffer layer 225. For example, in the second emission area EA2, a second light-emitting structure 222b may be arranged on the first functional layer 221, a light-emitting element buffer layer 225 may be arranged on the second light-emitting structure 222b, and a fourth functional layer 226 may be arranged on the light-emitting element buffer layer 225. For example, in the third emission area EA3, a lower light-emitting structure 222Lc may be arranged on the first functional layer 221, a second functional layer 223 may be arranged on the lower light-emitting structure 222Lc, a charge generation layer CGL may be arranged on the second functional layer 223, a third functional layer 224 may be arranged on the charge generation layer CGL, an upper light-emitting structure 222Uc may be arranged on the third functional layer 224, a light-emitting element buffer layer 225 may be arranged on the upper light-emitting structure 222Uc, and a fourth functional layer 226 may be arranged on the light-emitting element buffer layer 225.

The first intermediate layer 220a may be arranged to overlap with the first emission area EA1 defined by the first pixel opening 130OP1. For example, at least a portion of the first light-emitting structure 222a may be arranged within the first pixel opening 130OP1. For example, at least a portion of the first emission layer 222ma (e.g., see FIG. 3) may be arranged within the first pixel opening 130OP1.

The second intermediate layer 220b may be arranged to overlap with the second emission area EA2 defined by the second pixel opening 130OP2. For example, at least a portion of the second light-emitting structure 222b may be arranged within the second pixel opening 130OP2. For example, at least a portion of the second emission layer 222mb (e.g., see FIG. 3) may be arranged within the second pixel opening 130OP2.

The third intermediate layer 220c may be arranged to overlap with the third emission area EA3 defined by the third pixel opening 130OP3. For example, the first emitting unit EU1, the second emitting unit EU2, and the charge generation layer CGL may overlap with the third emission area EA3. For example, at least a portion of the lower light-emitting structure 222Lc may be arranged within the third pixel opening 130OP3. For example, at least a portion of the upper light-emitting structure 222Uc may be arranged within the third pixel opening 130OP3. For example, at least a portion of the lower emission layer 222Lmc (e.g., see FIG. 3) and at least a portion of the upper emission layer 222Umc may be arranged within the third pixel opening 130OP3.

For example, at least a portion of the charge generation layer CGL may overlap with the third emission area EA3, and may be arranged within the third pixel opening 130OP3. For example, at least a portion of each of the negative charge generation layer n-CGL and the positive charge generation layer p-CGL may overlap with the third emission area EA3, and may be arranged within the third pixel opening 130OP3. For example, the charge generation layer CGL may not overlap with each of the first pixel opening 130OP1 and the second pixel opening 130OP2. In other words, the charge generation layer CGL may not overlap with each of the first emission area EA1 and the second emission area EA2. In other words, the charge generation layer CGL is spaced apart from each of the first emission area EA1 and the second emission area EA2 in a plan view.

For example, at least a portion of each of the second functional layer 223 and the third functional layer 224 may overlap with the third emission area EA3, and may be arranged within the third pixel opening 130OP3. For example, each of the second functional layer 223 and the third functional layer 224 may not overlap with the first pixel opening 130OP1 and the second pixel opening 130OP2. In other words, each of the second functional layer 223 and the third functional layer 224 may not overlap with the first emission area EA1 and the second emission area EA2. In other words, each of the second functional layer 223 and the third functional layer 224 may be spaced apart from the first emission area EA1 and the second emission area EA2 in a plan view.

The light-emitting element buffer layer 225 may be arranged on the first light-emitting structure 222a, the second light-emitting structure 222b, and the upper light-emitting structure 222Uc. The fourth functional layer 226 may be arranged on the light-emitting element buffer layer 225. Each of the light-emitting element buffer layer 225 and the fourth functional layer 226 may be integrally provided (e.g., commonly provided) across the first light-emitting element LED1, the second light-emitting element LED2, and the third light-emitting element LED3.

An opposite electrode 230 may be arranged on the fourth functional layer 226. The opposite electrode 230 may be integrally provided (e.g., commonly provided) across the first light-emitting element LED1, the second light-emitting element LED2, and the third light-emitting element LED3.

A capping layer 235 may be arranged on the opposite electrode 230. The capping layer 235 may improve a light-emitting efficiency by a principle of constructive interference. The capping layer 235 may be an organic capping layer including an organic material, an inorganic capping layer including an inorganic material, or a composite capping layer including an organic material and an inorganic material. In an embodiment, the capping layer 235 may include lithium fluoride (LiF). The capping layer 235 may be integrally provided (e.g., commonly provided) across the first light-emitting element LED1, the second light-emitting element LED2, and the third light-emitting element LED3.

In an embodiment, as illustrated in FIG. 5, the first light-emitting structure 222a and the second light-emitting structure 222b may be arranged to overlap with each other on the pixel-defining layer 130 between the first pixel opening 130OP1 and the second pixel opening 130OP2. For example, a portion of the first emission layer 222ma (e.g., see FIG. 3) and a portion of the second emission layer 222mb may be arranged to overlap with each other on the pixel-defining layer 130 between the first pixel opening 130OP1 and the second pixel opening 130OP2.

Referring to FIGS. 5 and 6, in an embodiment, the second light-emitting structure 222b and each of the first emitting unit EU1, the charge generation layer CGL, and the second emitting unit EU2 of the third light-emitting element LED3 may be arranged to overlap with each other on the pixel-defining layer 130 between the second pixel opening 130OP2 and the third pixel opening 130OP3. For example, the first functional layer 221, the second emission auxiliary layer 222ab, the second emission layer 222mb, the lower emission auxiliary layer 222Lac, the lower emission layer 222Lmc, the second functional layer 223, the charge generation layer CGL, the third functional layer 224, the upper emission auxiliary layer 222Uac, and the upper emission layer 222Umc may be arranged to overlap with each other on the pixel-defining layer 130 between the second pixel opening 130OP2 and the third pixel opening 130OP3.

In an embodiment, between the second pixel opening 130OP2 and the third pixel opening 130OP3, the second light-emitting structure 222b of the second light-emitting element LED2 including a single stack structure may be arranged on the pixel-defining layer 130, and the lower light-emitting structure 222Lc, the second functional layer 223, the charge generation layer CGL, the third functional layer 224, and the upper light-emitting structure 222Uc of the third light-emitting element LED3 including a multi-stacked structure may be arranged on the second light-emitting structure 222b of the second light-emitting element LED2. For example, between the second pixel opening 130OP2 and the third pixel opening 130OP3, the first functional layer 221, the second emission auxiliary layer 222ab, the second emission layer 222mb, the lower emission auxiliary layer 222Lac, the lower emission layer 222Lmc, the second functional layer 223, the charge generation layer CGL, the third functional layer 224, the upper emission auxiliary layer 222Uac, and the upper emission layer 222Umc may be sequentially stacked on the pixel-defining layer 130.

In an embodiment, after the second light-emitting structure 222b of the second light-emitting element LED2 including the single stack structure is formed, the lower light-emitting structure 222Lc, the second functional layer 223, the charge generation layer CGL, the third functional layer 224, and the upper light-emitting structure 222Uc of the third light-emitting element LED3 including the multi-stacked structure may be formed. Accordingly, between the second pixel opening 130OP2 and the third pixel opening 130OP3, a distance between the upper surface of the pixel-defining layer 130 and the lower surface of the second emission layer 222mb of the second light-emitting element LED2 may be less than a distance between the upper surface of the pixel-defining layer 130 and the lower surface of the lower emission layer 222Lmc of the third light-emitting element LED3.

Because the second light-emitting structure 222b is arranged between the first-2 functional layer 221-2 and the lower light-emitting structure 222Lc of the third light-emitting element LED3 between the second pixel opening 130OP2 and the third pixel opening 130OP3, a first distance D1 between the upper surface of the first-1 functional layer 221-1 arranged on the pixel-defining layer 130 between the second pixel opening 130OP2 and the third pixel opening 130OP3 and the lower surface of the charge generation layer CGL (e.g., the lower surface of the negative charge generation layer n-CGL) may be greater than a sum of the thickness of the first-2 functional layer 221-2 arranged within the third pixel opening 130OP3, the thickness of the lower emission layer 222Lmc arranged within the third pixel opening 130OP3, and the thickness of the second functional layer 223 arranged within the third pixel opening 130OP3. For example, the first distance D1 between the upper surface of the first-1 functional layer 221-1 arranged on the pixel-defining layer 130 between the second pixel opening 130OP2 and the third pixel opening 130OP3 and the lower surface of the charge generation layer CGL (e.g., the lower surface of the negative charge generation layer n-CGL) may be greater than the sum of the thickness of the first-2 functional layer 221-2 arranged within the third pixel opening 130OP3, the thickness of the lower emission auxiliary layer 222Lac arranged within the third pixel opening 130OP3, the thickness of the lower emission layer 222Lmc arranged within the third pixel opening 130OP3, and the thickness of the second functional layer 223 arranged within the third pixel opening 130OP3. For example, the first distance D1 may be within a range of about 700 Å to about 2450 Å. For example, the first distance D1 may be within a range of about 700 Å to about 2700 Å. When the first distance D1 is less than the above-described ranges, a lateral current leakage may increase, and thus, a display quality may deteriorate. When the first distance D1 is greater than the above-described ranges, it may be difficult to form a thin display panel 1.

If (e.g., when) the light-emitting structures and the charge generation layer CGL of the third light-emitting element LED3 are formed after the second light-emitting structure 222b of the second light-emitting element LED2 is formed, the first distance D1 between the upper surface of the first-1 functional layer 221-1 and the lower surface of the charge generation layer CGL may be relatively greater than in a comparative example in which the light-emitting structures and the charge generation layer CGL of the third light-emitting element LED3 are formed before the second light-emitting structure 222b of the second light-emitting element LED2 is formed. Accordingly, the lateral current leakage that may occur when the distance between the first-1 functional layer 221-1 and the charge generation layer CGL is relatively smaller may be prevented or reduced.

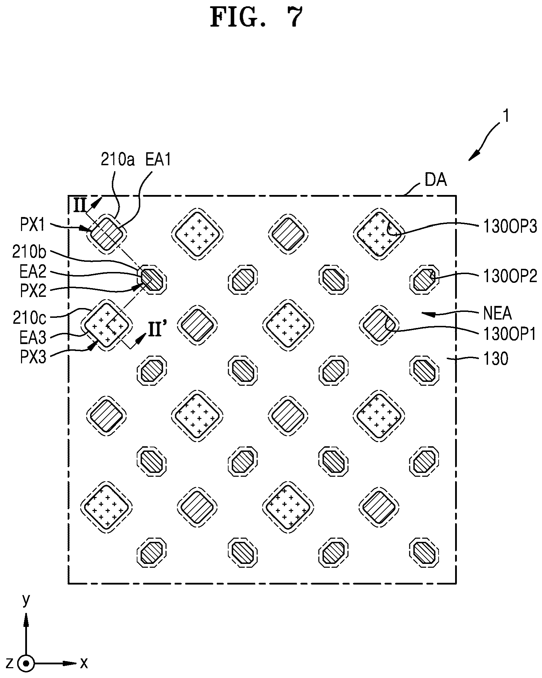

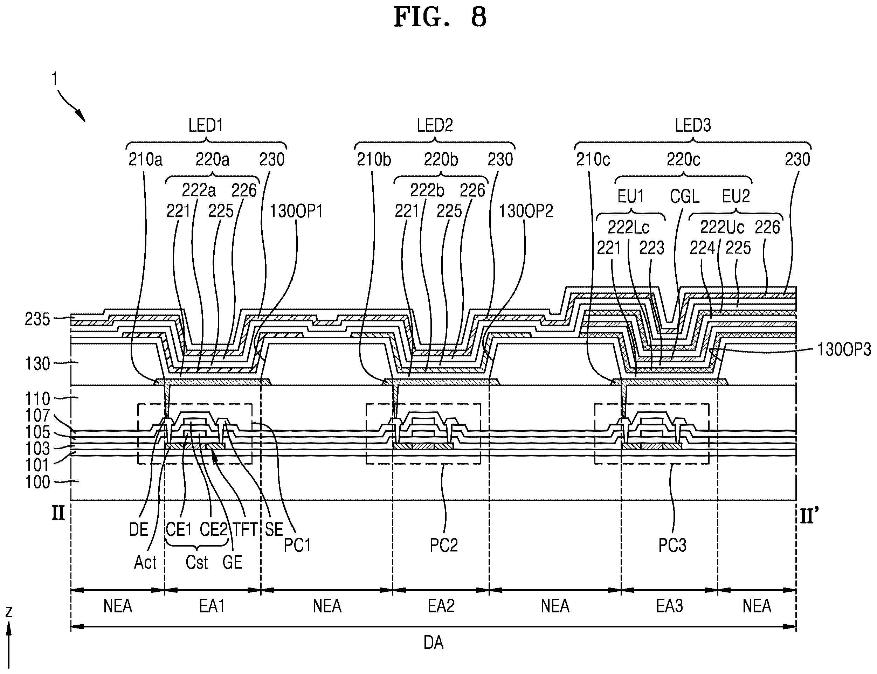

FIG. 7 is a plan view schematically illustrating a display area DA of a display panel 1 according to an embodiment. FIG. 8 is a cross-sectional view schematically illustrating a cross-section taken along the line II-II' of FIG. 7.

The embodiment illustrated in FIGS. 7 and 8 will be described in more detail hereinafter with a focus on the differences from those described above with reference to FIGS. 4 to 6, and redundant description thereof may not be repeated. In FIGS. 7 and 8, a smaller number of pixels may be arranged per unit area than that of FIGS. 4 to 6.

Referring to FIGS. 7 and 8, the second light-emitting structure 222b and each of the first emitting unit EU1, the charge generation layer CGL, and the second emitting unit EU2 of the third light-emitting element LED3 may not overlap with each other between the second pixel opening 130OP2 and the third pixel opening 130OP3. For example, between the second pixel opening 130OP2 and the third pixel opening 130OP3, the second light-emitting structure 222b including the second emission auxiliary layer 222ab (e.g., see FIG. 3) and the second emission layer 222mb may not overlap with the lower emission auxiliary layer 222Lac, the lower emission layer 222Lmc, the second functional layer 223, the charge generation layer CGL, the third functional layer 224, the upper emission auxiliary layer 222Uac, and the upper emission layer 222Umc. For example, between the second pixel opening 130OP2 and the third pixel opening 130OP3, the second light-emitting structure 222b including the second emission auxiliary layer 222ab (e.g., see FIG. 3) and the second emission layer 222mb may not overlap with the lower emission auxiliary layer 222Lac, the lower emission layer 222Lmc, the second functional layer 223, the charge generation layer CGL, the third functional layer 224, the upper emission auxiliary layer 222Uac, and the upper emission layer 222Umc.

Between the second pixel opening 130OP2 and the third pixel opening 130OP3, the second light-emitting structure 222b and each of the first emitting unit EU1, the charge generation layer CGL, and the second emitting unit EU2 of the third light-emitting element LED3 may be spaced apart from each other in a plan view. For example, the second emission layer 222mb (e.g., see FIG. 3) may be spaced apart from the lower emission layer 222Lmc, the second functional layer 223, the charge generation layer CGL, the third functional layer 224, and the upper emission layer 222Umc in a plan view.

According to the embodiments described above with reference to FIGS. 1 to 8, the third light-emitting element LED3 may include two or more emission layers (e.g., the lower emission layer 222Lmc and the upper emission layer 222Umc), the first light-emitting element LED1 may include a single emission layer (e.g., the first emission layer 222ma), and the second light-emitting element LED2 may include a single emission layer (e.g., the second emission layer 222mb). In other words, the number of emission layers of the third light-emitting element LED3 may be greater than each of the number of emission layers of the first light-emitting element LED1 and the number of emission layers of the second light-emitting element LED2.

The embodiments described above with reference to FIGS. 1 to 8 may improve a light-emitting efficiency and a lifespan of the display panel 1 as compared to those of a comparative example, in which all of the light-emitting elements included in the display panel are single-stack structure light-emitting elements, by using both a single-stack structure light-emitting element (e.g., the first light-emitting element LED1 and the second light-emitting element LED2) and a tandem light-emitting element (e.g., the third light-emitting element LED3).

The embodiments described above with reference to FIGS. 1 to 8 may reduce a lateral current leakage as compared to that of a comparative example, in which all of the light-emitting elements included in the display panel are multi-stack structure light-emitting elements, by using both a single-stack structure light-emitting element (e.g., the first light-emitting element LED1 and the second light-emitting element LED2) and a multi-stack structure light-emitting element (e.g., the third light-emitting element LED3). Accordingly, an occurrence of a low-level color mixing (e.g., a gray crushing) may be reduced or prevented, thereby improving the display quality of the display panel 1.

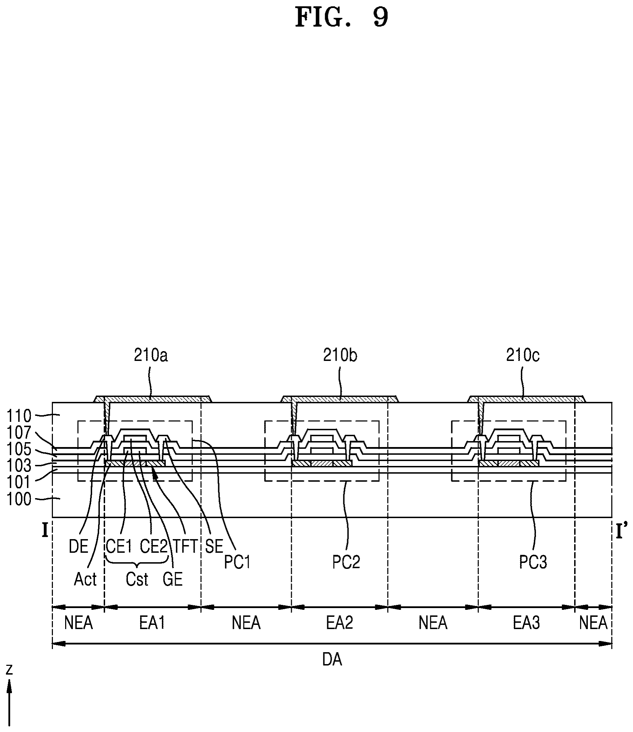

FIGS. 9 through 16 are cross-sectional views schematically illustrating a method of manufacturing a display panel according to an embodiment. FIGS. 9 through 16 sequentially show each manufacturing method operation in a cross-section corresponding to the cross-section of the display panel 1 according to the embodiment described above with reference to FIG. 5.

According to an embodiment, the method of manufacturing a display panel includes forming a first pixel electrode, a second pixel electrode, and a third pixel electrode, which are spaced apart from each other on a substrate, forming a first functional layer on the first pixel electrode, the second pixel electrode, and the third pixel electrode, forming one first emission layer on the first functional layer in a region overlapping with the first pixel electrode, forming one second emission layer on the first functional layer in a region overlapping with the second pixel electrode, and forming, in a region overlapping with the third pixel electrode, a lower emission layer on the first functional layer, a second functional layer on the lower emission layer, a charge generation layer on the second functional layer, a third functional layer on the charge generation layer, and an upper emission layer on the third functional layer. In this case, the charge generation layer may be spaced apart from the first pixel electrode and the second pixel electrode in a plan view.

The method of manufacturing a display panel, according to an embodiment, may further include forming a fourth functional layer on the first emission layer, the second emission layer, and the upper emission layer, and forming an opposite electrode on the fourth functional layer.

The method of manufacturing a display panel, according to an embodiment, may further include forming a pixel-defining layer arranged on the first pixel electrode, the second pixel electrode, and the third pixel electrode, the pixel-defining layer including a first pixel opening exposing a portion of the first pixel electrode, a second pixel opening exposing a portion of the second pixel electrode, and a third pixel opening exposing a portion of the third pixel electrode.

FIG. 9 illustrates an operation of forming the first pixel electrode, the second pixel electrode, and the third pixel electrode, which are spaced apart from each other on a substrate 100.

Referring to FIG. 9, a first pixel circuit PC1, a second pixel circuit PC2, and a third pixel circuit PC3, each including a transistor TFT and a capacitor Cst, may be formed on the substrate 100. For example, a buffer layer 101 may be formed on the substrate 100, and the first pixel circuit PC1, the second pixel circuit PC2, and the third pixel circuit PC3 may be formed on the buffer layer 101. The transistor TFT may include an active layer Act, a gate electrode GE, a source electrode SE, and a drain electrode DE. The capacitor Cst may include a first capacitor electrode CE1 and a second capacitor electrode CE2.

The active layer Act may be formed on the buffer layer 101. A gate insulating layer 103 may be formed on the active layer Act. The gate electrode GE may be formed on the gate insulating layer 103 to overlap with the active layer Act in a plan view. A first interlayer insulating layer 105 may be formed on the gate electrode GE. The second capacitor electrode CE2 may be formed on the first interlayer insulating layer 105. At least a portion of the gate electrode GE may overlap with the second capacitor electrode CE2 in a plan view. For example, the gate electrode GE may function as the first capacitor electrode CE1 of the capacitor Cst. A second interlayer insulating layer 107 may be formed on the second capacitor electrode CE2. The source electrode SE and the drain electrode DE may be formed on the second interlayer insulating layer 107.

Each of the gate insulating layer 103, the first interlayer insulating layer 105, and the second interlayer insulating layer 107 may include an inorganic material, such as silicon oxide, silicon nitride, and/or silicon oxynitride, and may include multilayers or a single layer including at least one of the aforementioned materials.

A via insulating layer 110 may be formed on the first pixel circuit PC1, the second pixel circuit PC2, and the third pixel circuit PC3. For example, the via insulating layer 110 may be formed on the second interlayer insulating layer 107. The via insulating layer 110 may be a planarization layer having a flat or substantially flat upper surface. The via insulating layer 110 may include an organic insulating material. For example, the via insulating layer 110 may include benzocyclobutene (BCB), hexamethyldisiloxane (HMDSO), polystyrene, a polymer derivative having a phenol-based group, an acryl-based polymer (e.g., polymethylmethacrylate (PMMA)), an imide-based polymer (e.g., polyimide), an acryl ether-based polymer, an amide-based polymer, a fluorine-based polymer, a p-xylene-based polymer, a vinyl alcohol-based polymer, a suitable blend thereof, or the like.

A first pixel electrode 210a, a second pixel electrode 210b, and a third pixel electrode 210c may be formed on the via insulating layer 110. The first pixel electrode 210a, the second pixel electrode 210b, and the third pixel electrode 210c may be spaced apart from each other.

Each of the first pixel electrode 210a, the second pixel electrode 210b, and the third pixel electrode 210c may include a transparent conductive oxide, such as indium tin oxide (ITO), indium zinc oxide (IZO), zinc oxide (ZnO), indium oxide (In₂O₃), indium gallium oxide (IGO), indium gallium zinc oxide (IGZO), gallium zinc oxide (GZO), or aluminium zinc oxide (AZO). Each of the first pixel electrode 210a, the second pixel electrode 210b, and the third pixel electrode 210c may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a suitable compound thereof. For example, each of the first pixel electrode 210a, the second pixel electrode 210b, and the third pixel electrode 210c may have a three-layered structure including ITO/Ag/ITO layers.

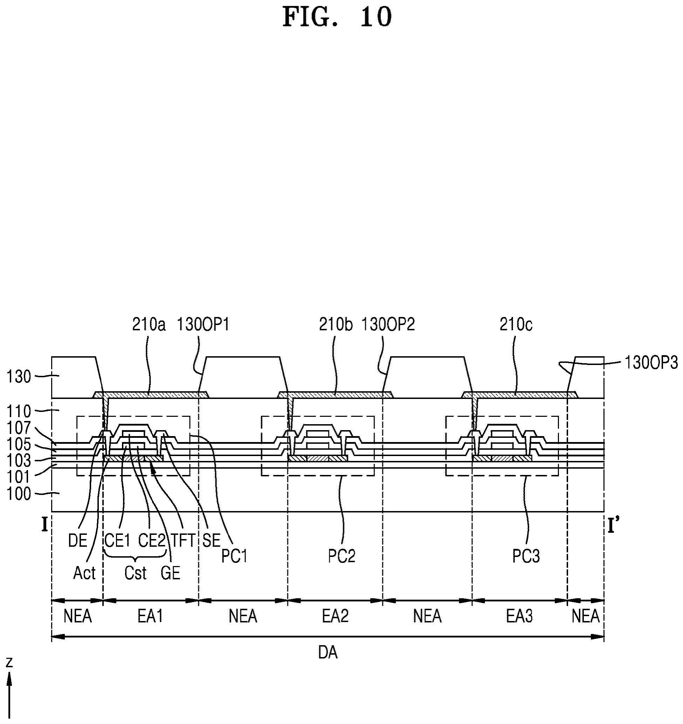

FIG. 10 illustrates an operation of forming the pixel-defining layer arranged on the first pixel electrode, the second pixel electrode, and the third pixel electrode, the pixel-defining layer including the first pixel opening exposing a portion of the first pixel electrode, the second pixel opening exposing a portion of the second pixel electrode, and the third pixel opening exposing a portion of the third pixel electrode.

Referring to FIG. 10, the pixel-defining layer 130 may be formed on the first pixel electrode 210a, the second pixel electrode 210b, and the third pixel electrode 210c. A portion of the pixel-defining layer 130 may be removed to form a first pixel opening 130OP1 that covers the edge of the first pixel electrode 210a and exposes a portion of the first pixel electrode 210a, a second pixel opening 130OP2 that covers the edge of the second pixel electrode 210b and exposes a portion of the second pixel electrode 210b, and a third pixel opening 130OP3 that covers the edge of the third pixel electrode 210c and exposes a portion of the third pixel electrode 210c.

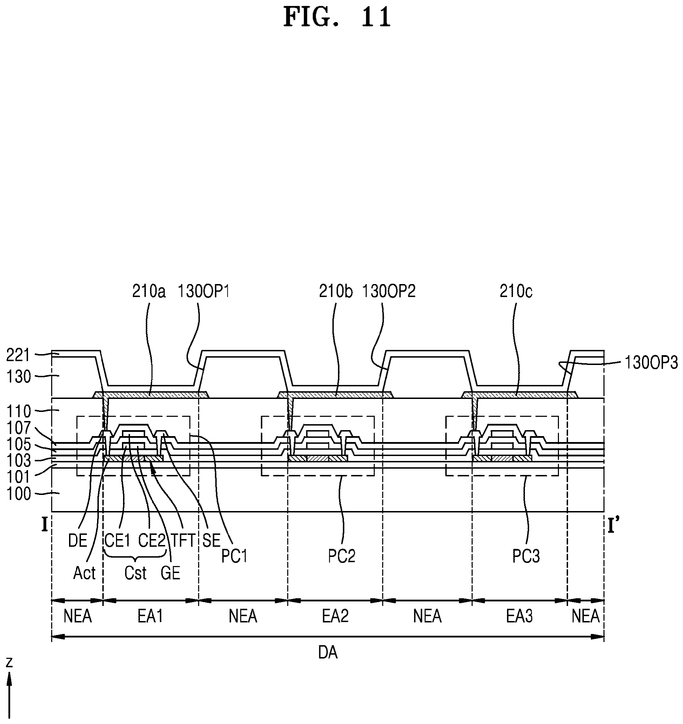

FIG. 11 illustrates an operation of forming the first functional layer on the first pixel electrode, the second pixel electrode, and the third pixel electrode.

Referring to FIG. 11, the first functional layer 221 may be formed on the first pixel electrode 210a, the second pixel electrode 210b, the third pixel electrode 210c, and the pixel-defining layer 130. For example, the first functional layer 221 may be integrally formed (e.g., commonly provided) across the first pixel electrode 210a, the second pixel electrode 210b, and the third pixel electrode 210c.

The first functional layer 221 may include a first-1 functional layer 221-1 (e.g., see FIG. 3) and a first-2 functional layer 221-2. For example, the first-1 functional layer 221-1 (e.g., see FIG. 3) may be formed on the first pixel electrode 210a, the second pixel electrode 210b, the third pixel electrode 210c, and the pixel-defining layer 130, and the first-2 functional layer 221-2 may be formed on the first-1 functional layer 221-1.

In FIG. 11, for convenience of illustration, the thickness of the first functional layer 221 is illustrated as being uniform or substantially uniform, but the present disclosure is not limited thereto. For example, as illustrated in FIG. 3, because the thickness of the first-2 functional layer 221-2 may differ between a region corresponding to the first pixel electrode 210a, a region corresponding to the second pixel electrode 210b, and a region corresponding to the third pixel electrode 210c, the first functional layer 221 may be formed to be thinner in the region corresponding to the third pixel electrode 210c than in the regions corresponding to the first pixel electrode 210a and the second pixel electrode 210b.

The first-1 functional layer 221-1 may include an HIL, and the first-2 functional layer 221-2 may include an HTL.

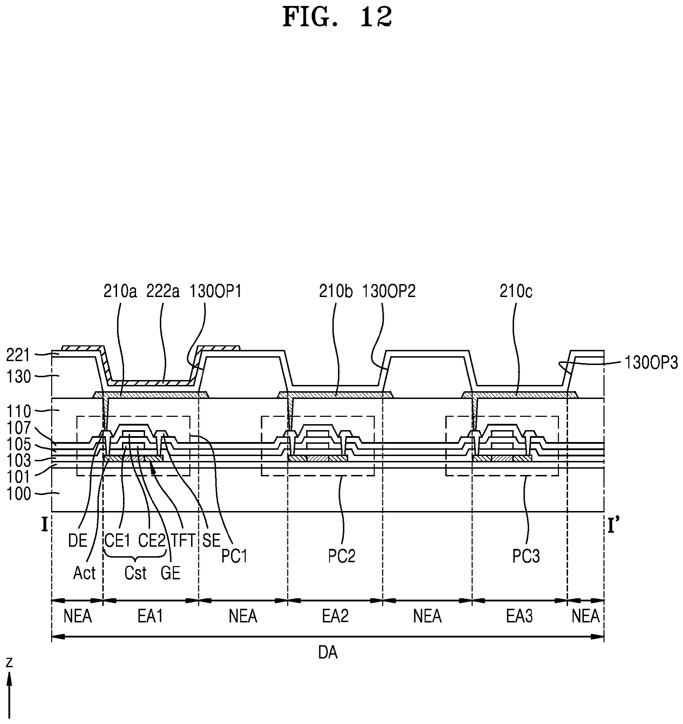

FIG. 12 illustrates an operation of forming a single first emission layer on the first functional layer in a region overlapping with the first pixel electrode.

Referring to FIG. 12, a first light-emitting structure 222a including a single first emission layer 222ma (e.g., see FIG. 3) may be formed on the first functional layer 221 in a region overlapping with the first pixel electrode 210a (e.g., a region overlapping with the first emission area EA1). For example, in a region overlapping with the first pixel electrode 210a, a first emission auxiliary layer 222aa (e.g., see FIG. 3) may be formed on the first functional layer 221, and a first emission layer 222ma may be formed on the first emission auxiliary layer 222aa.

In an embodiment, each of the first emission auxiliary layer 222aa (e.g., see FIG. 3) and the first emission layer 222ma may be deposited on a region overlapping with the first pixel electrode 210a (e.g., a region overlapping with the first emission area EA1) by using a deposition mask (e.g., a fine metal mask (FMM)).

In an embodiment, at least a portion of the first light-emitting structure 222a may be formed within the first pixel opening 130OP1. For example, at least a portion of the first emission auxiliary layer 222aa (e.g., see FIG. 3) and at least a portion of the first emission layer 222ma may be formed within the first pixel opening 130OP1.

The first emission layer 222ma may include, for example, an organic material including a fluorescent or a phosphorescent material that emits a red light, a green light, or a blue light. The first emission layer 222ma may be, for example, an organic emission layer including a low-molecular weight organic material or a high-molecular weight organic material.

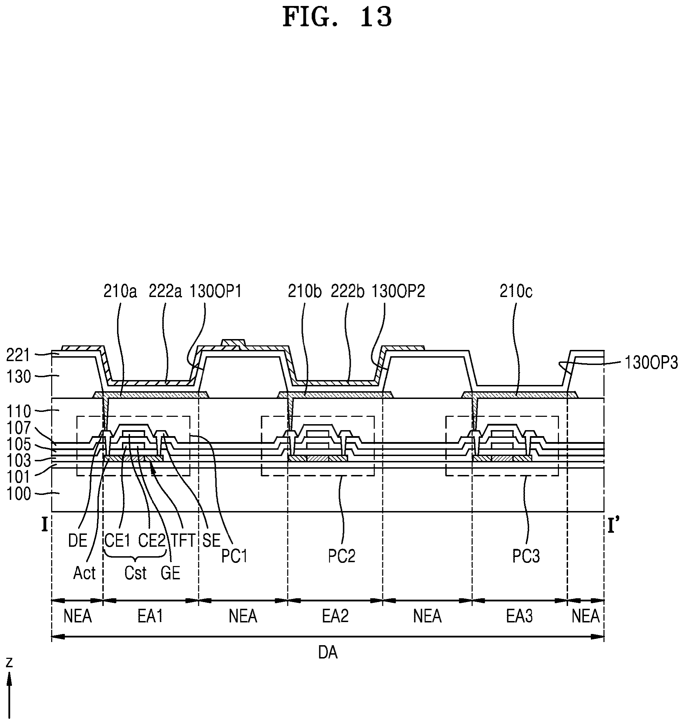

FIG. 13 illustrates an operation of forming a single second emission layer on the first functional layer in a region overlapping with the second pixel electrode.

Referring to FIG. 13, a second light-emitting structure 222b including a single second emission layer 222mb (e.g., see FIG. 3) may be formed on the first functional layer 221 in a region overlapping with the second pixel electrode 210b (e.g., a region overlapping with the second emission area EA2). For example, in a region overlapping with the second pixel electrode 210b, a second emission auxiliary layer 222ab (e.g., see FIG. 3) may be formed on the first functional layer 221, and a second emission layer 222mb may be formed on the second emission auxiliary layer 222ab.

In an embodiment, each of the second emission auxiliary layer 222ab (e.g., see FIG. 3) and the second emission layer 222mb may be deposited on a region overlapping with the second pixel electrode 210b (e.g., a region overlapping with the second emission area EA2) by using a deposition mask (e.g., an FMM).

The second emission layer 222mb may include an organic material including a fluorescent or a phosphorescent material that emits light of a different color than that of the first emission layer 222ma. The second emission layer 222mb may include an organic material including a fluorescent or a phosphorescent material that emits a red light, a green light, or a blue light, for example. The second emission layer 222mb may be an organic emission layer including, for example, a low-molecular weight organic material or a high-molecular weight organic material.

In an embodiment, at least a portion of the second light-emitting structure 222b may be formed within the second pixel opening 130OP2. For example, at least a portion of the second emission auxiliary layer 222ab (e.g., see FIG. 3) and at least a portion of the second emission layer 222mb may be formed within the second pixel opening 130OP2.

In an embodiment, as illustrated in FIG. 13, the first light-emitting structure 222a and the second light-emitting structure 222b may overlap with each other on the pixel-defining layer 130 between the first pixel opening 130OP1 and the second pixel opening 130OP2, but the present disclosure is not limited thereto. In an embodiment, as illustrated in FIG. 8, the first light-emitting structure 222a and the second light-emitting structure 222b may be formed on the pixel-defining layer 130 between the first pixel opening 130OP1 and the second pixel opening 130OP2 so as to not overlap with each other.

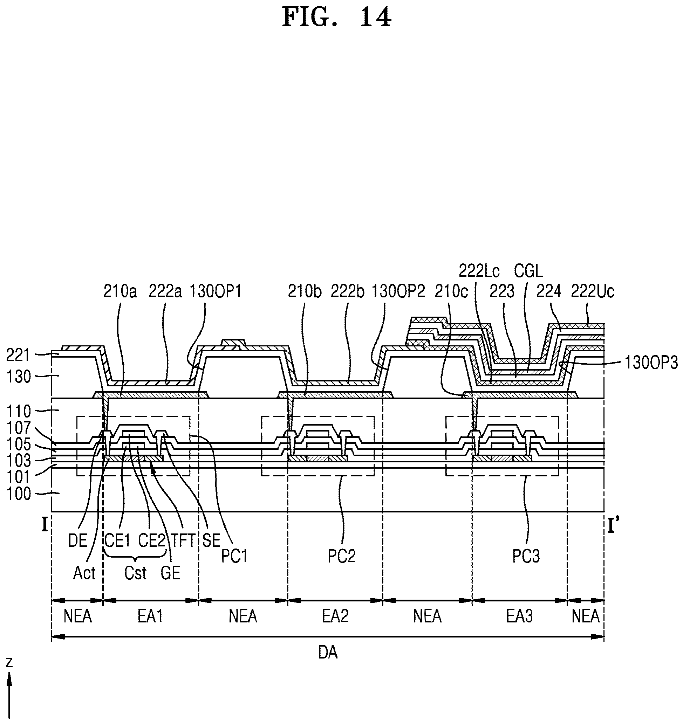

FIG. 14 illustrates an operation of forming a lower emission layer on a first functional layer, a second functional layer on the lower emission layer, a charge generation layer on the second functional layer, a third functional layer on the charge generation layer, and an upper emission layer on the third functional layer, in a region overlapping with the third pixel electrode. In an embodiment, an operation of forming a plurality of emission layers and a charge generation layer of the third light-emitting element may be performed after the forming of the emission layer of the first light-emitting element and the forming of the emission layer of the second light-emitting element.

Referring to FIG. 14, in a region overlapping with the third pixel electrode 210c (e.g., a region overlapping with the third emission area EA3), a lower light-emitting structure 222Lc including a lower emission layer 222Lmc (e.g., see FIG. 3) on the first functional layer 221, a second functional layer 223 on the lower light-emitting structure 222Lc, a charge generation layer CGL on the second functional layer 223, a third functional layer 224 on the charge generation layer CGL, and an upper light-emitting structure 222Uc including an upper emission layer 222Umc on the third functional layer 224 may be formed. For example, in a region overlapping with the third pixel electrode 210c, a lower emission auxiliary layer 222Lac (e.g., see FIG. 3), a lower emission layer 222Lmc, a second functional layer 223, a negative charge generation layer n-CGL, a positive charge generation layer p-CGL, a third functional layer 224, an upper emission auxiliary layer 222Uac, and an upper emission layer 222Umc may be sequentially formed on the first functional layer 221. Accordingly, a plurality of emission layers and a charge generation layer CGL arranged between the plurality of emission layers may be formed in a region overlapping with the third pixel electrode 210c.

In an embodiment, each of the lower emission auxiliary layer 222Lac (e.g., see FIG. 3), the lower emission layer 222Lmc, the second functional layer 223, the negative charge generation layer n-CGL, the positive charge generation layer p-CGL, the third functional layer 224, the upper emission auxiliary layer 222Uac, and the upper emission layer 222Umc may be deposited on a region overlapping with the third pixel electrode 210c (e.g., a region overlapping with the third emission area EA3) by using a deposition mask (e.g., an FMM). For example, each of the lower emission auxiliary layer 222Lac (e.g., see FIG. 3), the lower emission layer 222Lmc, the second functional layer 223, the negative charge generation layer n-CGL, the positive charge generation layer p-CGL, the third functional layer 224, the upper emission auxiliary layer 222Uac, and the upper emission layer 222Umc may be spaced apart from the first emission area EA1 and the second emission area EA2 in a plan view. For example, the charge generation layer CGL is spaced apart from the first pixel electrode 210a and the second pixel electrode 210b in a plan view.

In an embodiment, the operation of forming of the lower light-emitting structure 222Lc including the lower emission layer 222Lmc (e.g., see FIG. 3), the second functional layer 223, the charge generation layer CGL, the third functional layer 224, and the upper light-emitting structure 222Uc including the upper emission layer 222Umc may be performed after the forming of the first light-emitting structure 222a including the first emission layer 222ma and the forming of the second light-emitting structure 222b including the second emission layer 222mb. In other words, in a region overlapping with the third pixel electrode 210c, the forming of the lower emission layer 222Lmc (e.g., see FIG. 3) may be performed after the forming of the first emission layer 222ma and the forming of the second emission layer 222mb.

In an embodiment, at least a portion of the lower light-emitting structure 222Lc, at least a portion of the second functional layer 223, at least a portion of the upper light-emitting structure 222Uc, and at least a portion of the third functional layer 224 may each be formed within the third pixel opening 130OP3. For example, at least a portion of the lower emission auxiliary layer 222Lac (e.g., see FIG. 3), at least a portion of the lower emission layer 222Lmc, at least a portion of the upper emission auxiliary layer 222Uac, and at least a portion of the upper emission layer 222Umc may each be formed within the third pixel opening 130OP3.

In an embodiment, as illustrated in FIG. 14, the first functional layer 221, the second light-emitting structure 222b, the lower light-emitting structure 222Lc, the second functional layer 223, the charge generation layer CGL, the upper light-emitting structure 222Uc, and the third functional layer 224 may overlap with each other on the pixel-defining layer 130 between the second pixel opening 130OP2 and the third pixel opening 130OP3. In this case, because the forming of the lower emission layer 222Lmc (e.g., see FIG. 3) is performed after the forming of the first emission layer 222ma and the forming of the second emission layer 222mb, between the second pixel opening 130OP2 and the third pixel opening 130OP3, the first functional layer 221, the second emission auxiliary layer 222ab, the second emission layer 222mb, the lower emission auxiliary layer 222Lac, the lower emission layer 222Lmc, the second functional layer 223, the charge generation layer CGL, the third functional layer 224, the upper emission auxiliary layer 222Uac, and the upper emission layer 222Umc may be sequentially stacked on the pixel-defining layer 130.

In an embodiment, as illustrated in FIG. 8, the second light-emitting structure 222b and each of the lower light-emitting structure 222Lc, the second functional layer 223, the charge generation layer CGL, the third functional layer 224, and the upper light-emitting structure 222Uc may be formed so as not to overlap with each other on the pixel-defining layer 130 between the second pixel opening 130OP2 and the third pixel opening 130OP3. For example, the second light-emitting structure 222b may be formed to be spaced apart from each of the lower light-emitting structure 222Lc, the second functional layer 223, the charge generation layer CGL, the third functional layer 224, and the upper light-emitting structure 222Uc in a plan view.

The lower emission layer 222Lmc (e.g., see FIG. 3) and the upper emission layer 222Umc may include an organic material including a fluorescent or a phosphorescent material that emits light of the same color as each other. Each of the lower emission layer 222Lmc (e.g., see FIG. 3) and the upper emission layer 222Umc may include an organic material including a fluorescent or a phosphorescent material that emits light of a different color from that of the first emission layer 222ma and the second emission layer 222mb. The lower emission layer 222Lmc (e.g., see FIG. 3) and the upper emission layer 222Umc may each include an organic material including a fluorescent or a phosphorescent material that emits, for example, a red light, a green light, or a blue light. Each of the lower emission layer 222Lmc (e.g., see FIG. 3) and the upper emission layer 222Umc may be an organic emission layer including, for example, a low-molecular weight organic material or a high-molecular weight organic material.

The second functional layer 223 may include an ETL, and the third functional layer 224 may include an HTL.

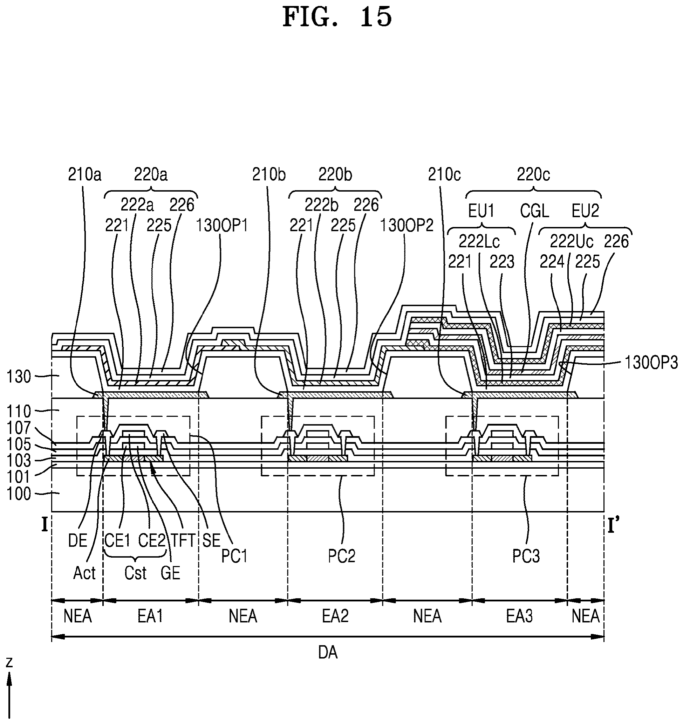

FIG. 15 illustrates an operation of forming the light-emitting element buffer layer and the fourth functional layer on the first emission layer, the second emission layer, and the upper emission layer.

Referring to FIG. 15, the light-emitting element buffer layer 225 may be formed on the first light-emitting structure 222a including the first emission layer 222ma (e.g., see FIG. 3), the second light-emitting structure 222b including the second emission layer 222mb, and the upper light-emitting structure 222Uc including the upper emission layer 222Umc. The fourth functional layer 226 may be formed on the light-emitting element buffer layer 225. For example, each of the light-emitting element buffer layer 225 and the fourth functional layer 226 may be integrally formed (e.g., commonly provided) across the first pixel electrode 210a, the second pixel electrode 210b, and the third pixel electrode 210c.

The light-emitting element buffer layer 225 may include an inorganic material, such as silicon oxide, silicon nitride, and/or silicon oxynitride.

The fourth functional layer 226 may have a single-layer structure or a multilayered structure. For example, the fourth functional layer 226 may include an ETL and/or an ElL.

The first functional layer 221, the first light-emitting structure 222a, the light-emitting element buffer layer 225, and the fourth functional layer 226 may form a first intermediate layer 220a. The first pixel electrode 210a, the first intermediate layer 220a, and the opposite electrode 230 may form a first light-emitting element LED1. The first functional layer 221, the second light-emitting structure 222b, the light-emitting element buffer layer 225, and the fourth functional layer 226 may form a second intermediate layer 220b. The second pixel electrode 210b, the second intermediate layer 220b, and the opposite electrode 230 may form a second light-emitting element LED2.

The first functional layer 221, the lower light-emitting structure 222Lc, and the second functional layer 223 may form a first emitting unit EU1. The third functional layer 224, the upper light-emitting structure 222Uc, the light-emitting element buffer layer 225, and the fourth functional layer 226 may form a second emitting unit EU2. The first emitting unit EU1, the second emitting unit EU2, and the charge generation layer CGL may form a third intermediate layer 220c. The third pixel electrode 210c, the third intermediate layer 220c, and the opposite electrode 230 may form a third light-emitting element LED3.

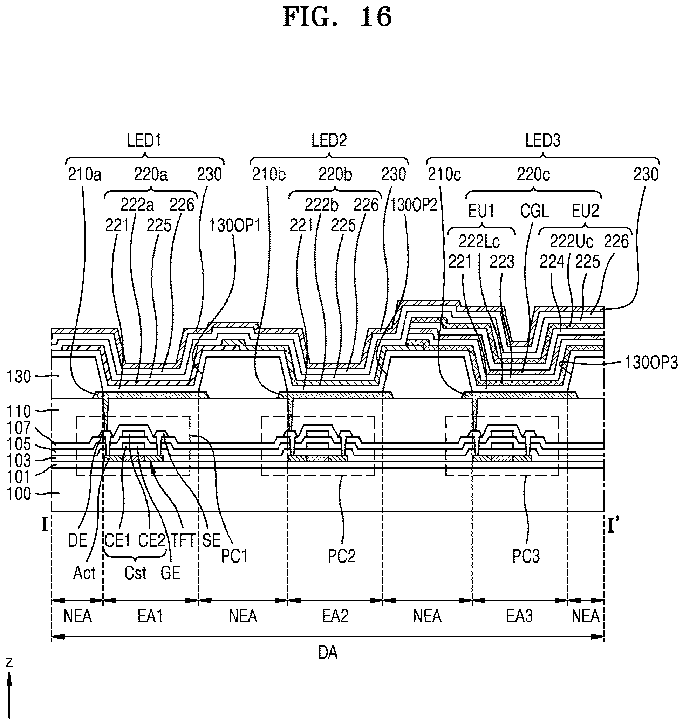

FIG. 16 illustrates an operation of forming the opposite electrode on the fourth functional layer.

Referring to FIG. 16, the opposite electrode 230 may be formed on the fourth functional layer 226. The opposite electrode 230 may be integrally formed (e.g., commonly provided) across the first to third light-emitting elements LED1, LED2, and LED3.

Referring again to FIG. 5, the capping layer 235 may be further formed on the opposite electrode 230. The capping layer 235 may be integrally formed (e.g., commonly provided) across the first to third light-emitting elements LED1, LED2, and LED3.

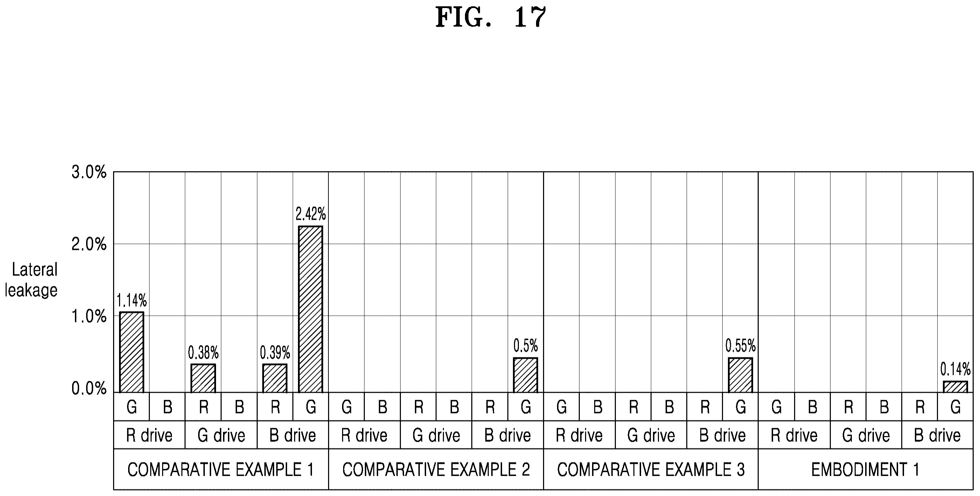

FIG. 17 is a graph illustrating a lateral leakage current ratio when driving a light-emitting element according to an embodiment, and a lateral leakage current ratio when driving a light-emitting element according to comparative examples.

The graph of FIG. 17 shows a lateral leakage current ratio in each of a green light-emitting element and a blue light-emitting element when a red light-emitting element is driven in each of a Comparative Example 1, a Comparative Example 2, a Comparative Example 3, and an Embodiment 1. The graph of FIG. 17 shows a lateral leakage current ratio in each of the red light-emitting element and the blue light-emitting element when the green light-emitting element is driven in each of the Comparative Example 1, the Comparative Example 2, the Comparative Example 3, and the Embodiment 1. The graph of FIG. 17 shows a lateral leakage current ratio in each of the red light-emitting element and the green light-emitting element when the blue light-emitting element is driven in each of the Comparative Example 1, the Comparative Example 2, the Comparative Example 3, and the Embodiment 1.

The Comparative Example 1 includes a red light-emitting element, a green light-emitting element, and a blue light-emitting element of a tandem structure.

Each of the Comparative Examples 2 and 3 include a red light-emitting element and a green light-emitting element of a single stack structure, and a blue light-emitting element of a tandem structure. In each of the Comparative Examples 2 and 3, a plurality of emission layers, functional layers, and a charge generation layer of the blue light-emitting element of the tandem structure are formed before the emission layer of the green light-emitting element is formed.

The Embodiment 1 includes a red light-emitting element and a green light-emitting element of a single stack structure, and a blue light-emitting element of a tandem structure. In the Embodiment 1, a plurality of emission layers, functional layers, and a charge generation layer of the blue light-emitting element of the tandem structure are formed after the emission layer of the green light-emitting element is formed.

Referring to FIG. 17, in the case of the Comparative Example 1 in which all light-emitting elements emitting light of different colors from each other have a tandem structure, a lateral current leakage occurs when driving the red light-emitting element (R drive), when driving the green light-emitting element (G drive), and when driving the blue light-emitting element (B drive). In more detail, when driving the red light-emitting element, a current leakage of 1.14% occurs in the green light-emitting element, when driving the green light-emitting element, a current leakage of 0.38% occurs in the red light-emitting element, and when driving the blue light-emitting element, a current leakage of 0.39% occurs in the red light-emitting element and a current leakage of 2.42% occurs in the green light-emitting element.

In the Comparative Examples 2 and 3, which include a red light-emitting element and a green light-emitting element in a single stack structure and a blue light-emitting element in a tandem structure, but in which the emission layers of the blue light-emitting element in the tandem structure are formed before the emission layers of the red light-emitting element and the green light-emitting element are formed, a lateral current leakage occurs when the blue light-emitting element is driven. In more detail, in the Comparative Examples 2 and 3, a current leakage of 0.5% and 0.55% occurs in the green light-emitting element when the blue light-emitting element is driven.

In the Embodiment 1, which includes a red light-emitting element and a green light-emitting element in a single stack structure and a blue light-emitting element in a tandem structure, but in which the emission layers of the blue light-emitting element in the tandem structure are formed after the emission layers of the red light-emitting element and the green light-emitting element are formed, a current leakage of 0.14% occurs when the blue light-emitting element is driven.

Accordingly, the Embodiment 1, in which only the blue light-emitting element is formed in a tandem structure and the remaining light-emitting elements are formed in a single stack structure, may significantly reduce a current leakage in all cases of driving the red, green, and/or blue light-emitting elements, compared to that of the Comparative Example 1, in which all light-emitting elements are formed in a tandem structure.

In addition, in the Comparative Examples 2 and 3, the current leakage when driving the blue light-emitting element is about 0.5% or more, which is about 3.5 times more current leakage than 0.14% in the Embodiment 1. In other words, when the emission layers of the blue light-emitting element in the tandem structure, as that in the Embodiment 1, are formed after the emission layers of the red light-emitting element and the green light-emitting element are formed, the current leakage may be reduced to about 1/3.5 or less of the current leakage in the Comparative Examples 2 and 3.

Accordingly, in some embodiments, a lateral current leakage may be significantly reduced, and a display quality may be improved when compared to those of the Comparative Examples, in which all light-emitting elements are multi-stack structure light-emitting elements. In addition, in some embodiments, in which the emission layers and charge generation layer of a light-emitting element in a tandem structure are formed after the emission layer of a light-emitting element in a single-stack structure is formed, a lateral current leakage may be significantly reduced, and a display quality may be improved compared to those of a comparative example in which the emission layer of a light-emitting element in a single-stack structure is formed after the emission layers and charge generation layer of a light-emitting element in a tandem structure are formed.

A display apparatus including the display panel 1 (e.g., see FIGS. 4 to 8) according to some embodiments described above, or a display panel manufactured according to the method (e.g., see FIGS. 9 to 16) of manufacturing a display panel according to some embodiments described above may be applied to various suitable electronic apparatuses. An electronic apparatus according to an embodiment includes a display apparatus including the above-described display panel, and may further include a module or apparatus having other additional functions in addition to the display apparatus.

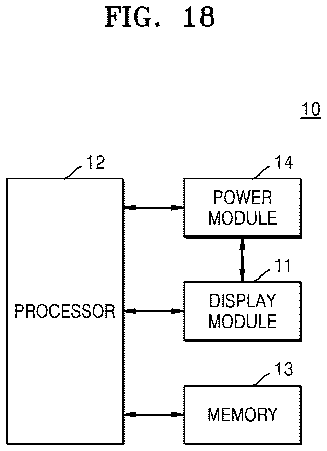

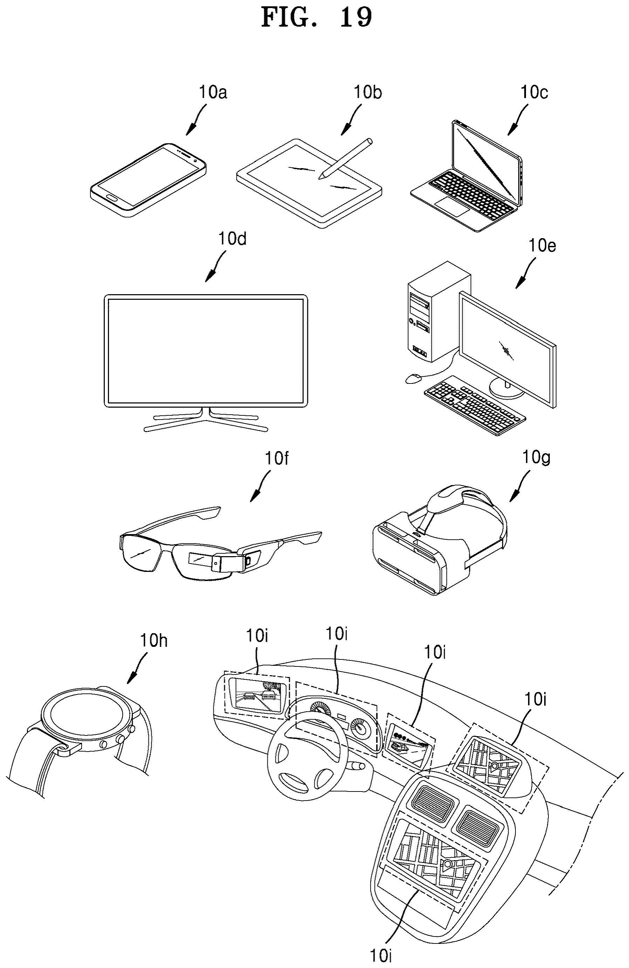

FIG. 18 is a block diagram of an electronic apparatus 10 according to an embodiment. FIG. 19 is schematic diagrams of electronic apparatuses according to some embodiments.

Referring to FIG. 18, the electronic apparatus 10 according to an embodiment may include a display module 11, a processor 12, a memory 13, and a power module (e.g., a power supply) 14.

The display module 11 includes the display panel 1 (e.g., see FIGS. 4 to 8) according to an embodiment. For example, the display module 11 may include the display panel 1 (e.g., see FIGS. 4 to 8) formed according to a method of manufacturing a display panel, according to an embodiment.

The processor 12 may include at least one of a central processing unit (CPU), an application processor (AP), a graphic processing unit (GPU), a communication processor (CP), an image signal processor (ISP), and/or a controller.

The memory 13 may store data information used for the operation of the processor 12 or the display module 11. When the processor 12 executes an application stored in the memory 13, an image data signal and/or an input control signal may be transmitted to the display module 11, and the display module 11 may process a received signal to output image information through a display screen.

The power module 14 may include a power supply module, such as a power adapter or a battery device, and a power conversion module that converts the power supplied by the power supply module to generate power used for the operation of the electronic apparatus 10.

At least one of the components of the electronic apparatus 10 may be included in a display apparatus including the display module 11. In addition, some of the individual modules functionally included in one module may be included in the display apparatus, and others may be provided separately from the display apparatus. For example, the display apparatus may include the display module 11, and the processor 12, the memory 13, and the power module 14 may be provided in the form of other apparatuses within the electronic apparatus 10 other than the display device.

Referring to FIG. 19, various electronic apparatuses including the display panel 1 (e.g., see FIGS. 4 to 8) according to some embodiments may include not only image display electronic apparatuses, such as a smart phone 10a, a tablet PC 10b, a laptop 10c, a TV 10d, and a desk monitor 10e, but also wearable electronic apparatuses including display modules, such as smart glasses 10f, a head-mounted display 10g, and a smart watch 10h, and vehicle electronic apparatuses 10i including display modules, such as a room mirror display and a Center Information Display (CID) arranged on an instrument panel, a center fascia, and/or a dashboard of an automobile.

The display panel and the electronic apparatus including the display panel, according to some embodiments, may include a light-emitting element including one emission layer and a light-emitting element including a plurality of emission layers, thereby preventing or reducing a current leakage between the light-emitting elements, and preventing or reducing color mixing defects, and thus, improving the display quality of the display panel and the electronic apparatus including the display panel. However, the present disclosure is not limited to the above aspects and features.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display panel (1) comprising:
a substrate (100) comprising a first emission area (EA1), a second emission area (EA2), and a third emission area (EA3);
a first light-emitting element (LED1) on the substrate (100), and corresponding to the first emission area (EA1) to emit light of a first color, the first light-emitting element (LED1) comprising a first pixel electrode (210a), a single first emission layer (222ma) on the first pixel electrode (210a), and an opposite electrode (230) on the first emission layer (222ma);
a second light-emitting element (LED2) on the substrate (100), and corresponding to the second emission area (EA2) to emit light of a second color, the second light-emitting element (LED2) comprising a second pixel electrode (210b), a single second emission layer (222mb) on the second pixel electrode (210b), and the opposite electrode (230) on the second emission layer (222mb); and
a third light-emitting element (LED3) on the substrate (100), and corresponding to the third emission area (EA3) to emit light of a third color, the third light-emitting element (LED3) comprising a third pixel electrode (210c), a lower emission layer (222Lmc) on the third pixel electrode (210c), a charge generation layer (CGL) on the lower emission layer (222Lmc), an upper emission layer (222Umc) on the charge generation layer (CGL), and the opposite electrode (230) on the upper emission layer (222Umc),
wherein the charge generation layer (CGL) is spaced from each of the first emission area (EA1) and the second emission area (EA2) in a plan view.

2. The display panel (1) of claim 1, wherein the third light-emitting element (LED3) has a greater number of emission layers than that of each of the first light-emitting element (LED1) and the second light-emitting element (LED2).

3. The display panel (1) of claim 1 or claim 2, wherein:
each of the first light-emitting element (LED1), the second light-emitting element (LED2), and the third light-emitting element (LED3) further comprises a first functional layer (221);
the third light-emitting element (LED3) further comprises a second functional layer (223) and a third functional layer (224);
the first functional layer (221) is located between the first pixel electrode (210a) and the first emission layer (222ma), between the second pixel electrode (210b) and the second emission layer (222mb), and between the third pixel electrode (210c) and the lower emission layer (222Lmc);
the second functional layer (223) is located between the lower emission layer (222Lmc) and the charge generation layer (CGL); and
the third functional layer (224) is located between the charge generation layer (CGL) and the upper emission layer (222Umc).

4. The display panel (1) of claim 3, wherein:
(i) each of the second functional layer (223) and the third functional layer (224) is spaced from the first emission area (EA1) and the second emission area (EA2) in the plan view; and/or
(ii) each of the first light-emitting element (LED1), the second light-emitting element (LED2), and the third light-emitting element (LED3) further comprises a fourth functional layer (226); and
the fourth functional layer (226) is located between the first emission layer (222ma) and the opposite electrode (230), between the second emission layer (222mb) and the opposite electrode (230), and between the upper emission layer (222Umc) and the opposite electrode (230).

5. The display panel (1) of claim 3 or claim 4, further comprising a pixel-defining layer (130) on the first pixel electrode (210a), the second pixel electrode (210b), and the third pixel electrode (210c), the pixel-defining layer (130) having a first pixel opening (130OP1) exposing a portion of the first pixel electrode (210a), a second pixel opening (130OP2) exposing a portion of the second pixel electrode (210b), and a third pixel opening (130OP3) exposing a portion of the third pixel electrode (210c).

6. The display panel (1) of claim 5, wherein:
the first functional layer (221), the second emission layer (222mb), the lower emission layer (222Lmc), the second functional layer (223), the charge generation layer (CGL), the third functional layer (224), and the upper emission layer (222Umc) overlap with each other on the pixel-defining layer (130) between the second pixel opening (130OP2) and the third pixel opening (130OP3); and
the first functional layer (221), the second emission layer (222mb), the lower emission layer (222Lmc), the second functional layer (223), the charge generation layer (CGL), the third functional layer (224), and the upper emission layer (222Umc) are sequentially stacked, optionally wherein the first functional layer (221) comprises a hole injection layer, and a hole transport layer on the hole injection layer, and
wherein between the second pixel opening (130OP2) and the third pixel opening (130OP3), a distance (D1) between an upper surface of the hole injection layer on the pixel-defining layer (130) and a lower surface of the charge generation layer (CGL) is greater than a sum of a thickness of the hole transport layer located within the third pixel opening (130OP3), a thickness of the lower emission layer (222Lmc) located within the third pixel opening (130OP3), and a thickness of the second functional layer (223) located within the third pixel opening (130OP3).

7. The display panel (1) of claim 5, wherein between the second pixel opening (130OP2) and the third pixel opening (130OP3), the second emission layer (222mb) and the lower emission layer (222Lmc) do not overlap with each other.

8. The display panel (1) of any one of claims 1 to 7, further comprising a capping layer (235) on the opposite electrode (230).

9. A method of manufacturing a display panel (1), the method comprising:
forming a first pixel electrode (210a), a second pixel electrode (210b), and a third pixel electrode (210c) to be spaced from each other on a substrate (100);
forming a first functional layer (221) on the first pixel electrode (210a), the second pixel electrode (210b), and the third pixel electrode (210c);
forming a single first emission layer (222ma) on the first functional layer (221) in a region overlapping with the first pixel electrode (210a);
forming a single second emission layer (222mb) on the first functional layer (221) in a region overlapping with the second pixel electrode (210b); and
forming, in a region overlapping with the third pixel electrode (210c), a lower emission layer (222Lmc) on the first functional layer (221), a second functional layer (223) on the lower emission layer (222Lmc), a charge generation layer (CGL) on the second functional layer (223), a third functional layer (224) on the charge generation layer (CGL), and an upper emission layer (222Umc) on the third functional layer (224),
wherein the charge generation layer (CGL) is spaced from the first pixel electrode (210a) and the second pixel electrode (210b) in a plan view.

10. The method of claim 9, wherein the forming of the lower emission layer (222Lmc) on the first functional layer (221) in the region overlapping with the third pixel electrode (210c) is performed after the forming of the first emission layer (222ma) and the forming of the second emission layer (222mb).

11. The method of claim 9 or claim 10, further comprising:
forming a fourth functional layer (226) on the first emission layer (222ma), the second emission layer (222mb), and the upper emission layer (222Umc); and
forming an opposite electrode (230) on the fourth functional layer (226).

12. The method of any one of claims 9 to 11, further comprising forming a pixel-defining layer (130) on the first pixel electrode (210a), the second pixel electrode (210b), and the third pixel electrode (210c), the pixel-defining layer (130) having a first pixel opening (130OP1) exposing a portion of the first pixel electrode (210a), a second pixel opening (130OP2) exposing a portion of the second pixel electrode (210b), and a third pixel opening (130OP3) exposing a portion of the third pixel electrode (210c).

13. The method of claim 12, wherein:
(i) the first functional layer (221), the second emission layer (222mb), the lower emission layer (222Lmc), the second functional layer (223), the charge generation layer (CGL), the third functional layer (224), and the upper emission layer (222Umc) are sequentially stacked on the pixel-defining layer (130) between the second pixel opening (130OP2) and the third pixel opening (130OP3); and/or
(ii) the first functional layer (221) comprises a hole injection layer, and a hole transport layer on the hole injection layer, and
wherein between the second pixel opening (130OP2) and the third pixel opening (130OP3), a distance between an upper surface of the hole injection layer on the pixel-defining layer (130) and a lower surface of the charge generation layer (CGL) is greater than a sum of a thickness of the hole transport layer arranged within the third pixel opening (130OP3), a thickness of the lower emission layer (222Lmc) arranged within the third pixel opening (130OP3), and a thickness of the second functional layer (223) arranged within the third pixel opening (130OP3).

14. An electronic apparatus (10) comprising:
a display module (11) comprising a display panel (1);
a processor (12);
a memory (13); and
a power module (14),
wherein the display panel (1) comprises:
a substrate (100) comprising a first emission area (EA1), a second emission area (EA2), and a third emission area (EA3);
a first light-emitting element (LED1) on the substrate (100), and corresponding to the first emission area (EA1) to emit light of a first color, the first light-emitting element (LED1) comprising a first pixel electrode (210a), one first emission layer (222ma) on the first pixel electrode (210a), and an opposite electrode (230) on the first emission layer (222ma);
a second light-emitting element (LED2) on the substrate (100), and corresponding to the second emission area (EA2) to emit light of a second color, the second light-emitting element (LED2) comprising a second pixel electrode (210b), one second emission layer (222mb) on the second pixel electrode (210b), and the opposite electrode (230) on the second emission layer (222mb); and
a third light-emitting element (LED3) on the substrate (100), and corresponding to the third emission area (EA3) to emit light of a third color, the third light-emitting element (LED3) comprising a third pixel electrode (210c), a lower emission layer (222Lmc) on the third pixel electrode (210c), a charge generation layer (CGL) on the lower emission layer (222Lmc), an upper emission layer (222Umc) on the charge generation layer (CGL), and the opposite electrode (230) on the upper emission layer (222Umc),
wherein the charge generation layer (CGL) is spaced from each of the first emission area (EA1) and the second emission area (EA2) in a plan view.

15. The electronic apparatus (10) of claim 14, wherein:
(i) the third light-emitting element (LED3) has a greater number of emission layers than that of each of the first light-emitting element (LED1) and the second light-emitting element (LED2); and/or
(ii) each of the first light-emitting element (LED1), the second light-emitting element (LED2), and the third light-emitting element (LED3) further comprises a first functional layer (221);
the third light-emitting element (LED3) further comprises a second functional layer (223) and a third functional layer (224);
the first functional layer (221) is located between the first pixel electrode (210a) and the first emission layer (222ma), between the second pixel electrode (210b) and the second emission layer (222mb), and between the third pixel electrode (210c) and the lower emission layer (222Lmc);
the second functional layer (223) is located between the lower emission layer (222Lmc) and the charge generation layer (CGL); and
the third functional layer (224) is located between the charge generation layer (CGL) and the upper emission layer (222Umc), optionally wherein each of the second functional layer (223) and the third functional layer (224) is spaced from the first emission area (EA1) and the second emission area (EA2) in the plan view.
